# EUROPEAN PATENT APPLICATION

(11) **EP 4 495 732 A1**
(43) Date of publication of application: **22.01.2025**
(21) Application number: 24188605.0
(22) Date of filing: 15.07.2024
(51) Int. Cl.: G06F 1/16, G09F 9/30, H04M 1/02

(54) **WINDOW GUIDE STRUCTURE AND DISPLAY DEVICE HAVING THE SAME**

(30) Priority: 20.07.2023 KR 20230094760
(71) Applicant: Samsung Display Co., Ltd., Gyeonggi-Do (KR)
(72) Inventor: Myung, Jung-Ho, Yongin-si, Gyeonggi-do (KR); Kim, Dae Won, Yongin-si, Gyeonggi-do (KR)
(74) Representative: Gulde & Partner

(57) **Abstract**

A display device includes a display panel including a display region at which the display panel is foldable or rollable, a window foldable or rollable together with the display panel and including first and second window end portions, and a bracket in which the display panel and the window are received. The bracket includes a first bracket corresponding to display region and the first and second window end portions, second and third brackets which extend from the first bracket and along which the first and second window end portions respectively extends, racket, a receiving groove defined by the first and third brackets and into which the second window portion extends to have a length overlapping the third bracket. Folding and unfolding (or rolling and unrolling) of the display panel includes varying of the length of the second window portion which overlaps the third bracket.

## Description

### BACKGROUND

### (1) Field

Embodiments of the present disclosure described herein relate to a display device.

### (2) Description of the Related Art

In general, a display device includes a display module for displaying an image and a support part for supporting the display module. The display module includes a display panel which displays an image, a window which is disposed on the display panel and protects the display panel from external scratches and impacts, and a protective layer which is disposed under the display panel and which protects the display panel from external impacts. The support part has a higher rigidity than the display module and supports the display module.

With the development of display device technology, flexible display devices capable of being deformed into various forms are being developed. The flexible display devices include a flexible display module which can be folded or rolled. A support part disposed under the flexible display module foldable about a folding axis has a structure foldable together with the flexible display module.

### SUMMARY

Embodiments of the present disclosure provide a display device with an increased display surface area and improved folding reliability.

According to an embodiment, a display panel, foldable about a folding axis, includes a first panel portion in which the folding axis is defined, a bending panel portion at which the display panel is bent, and a second panel portion arranged in a first direction, the folding axis of the display panel is extended in a second direction crossing the first direction, a window is disposed on the display panel, the window includes a first window portion adjacent to the bending panel portion and a second window portion which is spaced apart from the first window portion along the first direction, and a bracket in which the display panel and the window are received, includes, a first bracket corresponding to the first panel portion, the bending panel portion and the second panel portion, a second bracket which extends from the first bracket, toward the window, and covers the first window portion and, a third bracket which extends from the first bracket, toward the window, covers the second window portion. Folding and unfolding of the display panel about the folding axis includes movement of the second window portion along the first direction, within the bracket.

The display panel may further comprise a molded member between the window and the bracket, wherein the display panel which is bent at the bending panel portion may include the second panel portion overlapping the first panel portion, and the molded member covers the bending panel portion which is bent and the second panel portion which overlaps the first panel portion.

Within the bracket, a first receiving groove may be defined by the first bracket with the second bracket, a second receiving groove may be defined by the first bracket with the third bracket, the first window portion may extend along the second bracket and into the first receiving groove , along the first direction, and the second window portion may extend along the third bracket and into the second receiving groove , and the folding and unfolding of the display panel may move the second window portion along the third bracket, within the second receiving groove .

The display device may further comprise within the bracket: a protrusion which is connected to the bracket at an upper surface of the first bracket, the first receiving groove extended between the protrusion and the second bracket, and a first adhesive member which bonds the first window portion to the first bracket, at the protrusion.

The first panel portion of the display panel may include a first display region and a second display region at opposing sides of the folding axis.

The display panel may further comprise within the bracket, a guide which is between the window and the first bracket and along which the movement of the window is guided along the first direction.

The guide may include: a wheel between the window and the first bracket, and a track which is engaged with the wheel and moveable along the wheel, and the track may include: a first track portion between the wheel and the first bracket, a second track portion between the wheel and the window, and a bent track portion which connects the first track portion and the second track portion to each other; and the display panel which is unfolded may include: the first track portion having a length extended along the first bracket, the second track portion having a length extended along the window, and within the second receiving groove , the second window portion having a length extended along the third bracket.

In-folding of the display panel may include: the first display region and the second display region of the first panel portion facing each other, the length of the first track portion increased, the length of the second track portion decreased, and within the second receiving groove , the second window portion moved toward the first bracket and having the length of the second window portion increased.

Out-folding of the display panel may include: the first display region and the second display region of the first panel portion facing away from each other, the length of the first track portion decreased, the length of the second track portion increased, and within the second receiving groove , the second window portion moved away from the first bracket and having the length of the second window portion decreased.

The guide may include: a first guide plate which is connected to the first bracket and defines a guide groove of the first guide plate; and a second guide plate which is connected to the second window portion, the second guide plate including a guide rib moveable along the guide groove, in the first direction, and the display panel which is unfolded may include: the guide rib having a length within the guide groove, and within the second receiving groove , the second window portion having a length extended along the third bracket.

In-folding of the display panel may include: the first display region and the second display region of the first panel portion facing each other, the length of the guide rib decreased, and within the second receiving groove, the second window portion moved toward the first bracket and having the length of the second window portion increased.

Out-folding of the display panel may include: the first display region and the second display region facing away from each other, the length the guide rib increased, and within the second receiving groove , the second window portion moved away from the first bracket and having the length of second window portion decreased.

The guide may include a roller between the second window portion and the first bracket, and the display panel which is unfolded includes within the second receiving groove , the second window portion having a length extended along the third bracket, the length extended from the roller to an end of the window at the second window portion.

In-folding of the display panel may include: the first display region and the second display region of the first panel portion facing each other, and within the second receiving groove , the second window portion moved along the roller, toward the first bracket, and having the length of the second window portion increased.

Out-folding of the display panel may include: the first display region and the second display region facing away from each other, and within the second receiving groove , the second window portion moved along the roller, away from the first bracket, and having the length of the second window portion decreased.

The bracket may further include a fourth bracket extended in the first direction, the fourth bracket including: first sidewalls disposed on both sides of the first bracket opposing each other in the second direction and have a first width along the second direction, second sidewalls respectively extended from upper surface of the first sidewalls and having a second width in the second direction, and the first width greater than the second width, and the window further including a third window portion which is extended further than the display panel in the second direction and overlaps the upper surface of the first sidewalls.

The display device may further comprise a second adhesive member which is between the first sidewalls and the third window portion and bonds the first sidewalls and the window to each other, respectively.

The display device may further comprise: an edge of the third bracket which is furthest from the first bracket and a length of the third bracket which extends from the edge of the third bracket and overlaps the window, a gap which is defined between the length of the third bracket and the window which is overlapped by the length, the gap being open to outside the display device at the edge, and a tip portion which is within the gap.

According to an embodiment, a display panel includes a display region at which the display panel is rollable, a window is disposed on the display panel, the window includes a first window portion and a second window portion spaced apart from each other in a first direction, and a bracket in which the display panel and the window are received, includes a first bracket disposed under the display panel, a second bracket which extends from the first bracket and along which the first window portion extends, a third bracket which extends from the first bracket, is opposite to the second bracket along the first direction, and along which the second window portion extends to have a length overlapping the third bracket. A first receiving groove defined by the first bracket with the second bracket and into which the first window portion extends, and a second receiving groove defined by the first bracket with the third bracket and into which the second window portion extends. Rolling and unrolling of the display panel includes varying of the length of the second window portion which overlaps the third bracket.

The display panel may be rollable about a rolling axis extended in a second direction crossing the first direction.

The display device may further comprise within the bracket, a guide which is between the window and the first bracket and along which movement of the window is guided along the first direction.

The guide may include: a wheel between the window and the first bracket, and a track which is engaged with the wheel and moveable along the wheel, the track including:
a first track portion between the wheel and the first bracket, a second track portion between the wheel and the window, and a bent track portion which connects the first track portion and the second track portion to each other; and the display panel which is unrolled may include: the first track portion having a length extended along the first bracket, and the second track portion having a length extended along the window.

Out-rolling of the display panel may include: the display region exposed to outside the display panel, the length of the first track portion decreased, the length of the second track portion increased, and within the second receiving groove, the second window portion moved away from the first bracket and having the length of the second window portion decreased.

In-rolling of the display panel may include: the display region not exposed to outside the display panel, the length of the first track portion increased, the length of the second track portion decreased, and within the second receiving groove, the second window portion oved toward the first bracket and having the length of the second window portion increased.

The guide may include: a first guide plate which is connected to the first bracket and defines a guide groove of the first guide plate; and a second guide plate which is connected to the second window portion, the second guide plate including a guide rib moveable along the guide groove, in the first direction, and the display panel which is unrolled may include the guide rib having a length within the guide groove.

Out-rolling of the display panel may include: the display region exposed to outside the display panel, the length of the guide rib increased, and within the second receiving groove, the second window portion moved away from the first bracket and having the length of the second window portion decreased.

In-rolling of the display panel may include: the display region not exposed to outside the display panel, the length of the guide rib decreased, and within the second receiving groove, the second window portion moved toward the first bracket and having the length of the second window portion increased.

The guide may include a roller between the second window portion and the first bracket, and the display panel which is unrolled may include the length of the second window portion which is extended from the roller to an end of the window at the second window portion.

Out-rolling of the display panel may include: the display region exposed to outside the display panel, within the second receiving groove, the second window portion moved along the roller and away from the first bracket, and having the length of the second window portion decreased.

In-rolling of the display panel may include: the display region not exposed to outside the display panel, and within the second receiving groove, the second window portion moved along the roller and toward the first bracket, and having the length of the second window portion increased.

The display device may further comprise within the bracket: a protrusion which is connected to the bracket at an upper surface of the first bracket, the first receiving groove extended between the protrusion and the second bracket, and a first adhesive member which bonds the first window portion to the first bracket, at the protrusion.

The bracket may further include a fourth bracket extended in the first direction, the fourth bracket including: first sidewalls which are opposite to each other along a second direction crossing the first direction and have a first width along the second direction, second sidewalls respectively extended from upper surface of the first sidewalls and having a second width in the second direction, and the first width greater than the second width, and the window further including a third window portion is extended further than the display panel in the second direction and overlaps the upper surface of the first sidewalls.

The display device may further comprise a second adhesive member which is between the first sidewalls and the window and bonds the first sidewalls and the window to each other, respectively.

The display device may further comprise: an edge of the third bracket which is furthest from the first bracket and a length of the third bracket which extends from the edge of the third bracket and overlaps the window, a gap which is defined between the length of the third bracket and the window which is overlapped by the length, the gap open to outside the display device at the edge, and a tip portion which is within the gap.

### BRIEF DESCRIPTION OF THE FIGURES

The above and other objects and features of the present disclosure will become apparent by describing in detail embodiments thereof with reference to the accompanying drawings.
FIG. 1A is a perspective view of an electronic device according to an embodiment of the present disclosure.
FIG. 1B is a view illustrating a folded state of the electronic device illustrated in FIG. 1A.
FIG. 2A is a perspective view of an electronic device according to an embodiment of the present disclosure.
FIG. 2B is a view illustrating a folded state of the electronic device illustrated in FIG. 2A.
FIG. 3 is an exploded perspective view of the electronic device illustrated in FIGS. 1A and 1B.
FIG. 4 is a block diagram of the electronic device illustrated in FIG. 3.
FIG. 5 is a schematic cross-sectional view of a display module illustrated in FIG. 3.
FIG. 6 is a cross-sectional view of a display panel illustrated in FIG. 5.
FIG. 7 is a top plan view of the display panel illustrated in FIG. 3.
FIG. 8 is an enlarged cross-sectional view illustrating a section of an electronic panel corresponding to any one pixel illustrated in FIG. 7.
FIG. 9A is a cross-sectional view taken along line V-V' illustrated in FIG. 7.
FIG. 9B is a cross-sectional view illustrating a state in which a bending portion illustrated in FIG. 9A is bent.
FIG. 10 is a cross-sectional view taken along line VI-VI' illustrated in FIG. 7.
FIG. 11 is an enlarged cross-sectional view taken along line I-I' illustrated in FIG. 1A.
FIG. 12 is an enlarged cross-sectional view taken along line II-II' illustrated in FIG. 1A.
FIGS. 13A and 13B are cross-sectional views taken along line IV-IV' illustrated in FIG. 1B.
FIG. 14 is a cross-sectional view of an electronic device according to a comparative example.
FIGS. 15A to 15E are cross-sectional views for explaining a guide part according to an embodiment of the present disclosure.
FIG. 16 is a view for explaining a guide part according to an embodiment of the present disclosure.
FIG. 17A is a cross-sectional view taken along line III-III' illustrated in FIG. 1A.
FIG. 17B is a cross-sectional view taken along line III-III' according to an embodiment of the present disclosure.
FIG. 17C is a cross-sectional view taken along line III-III' according to an embodiment of the present disclosure.
FIGS. 18A and 18B are perspective views illustrating an electronic device according to an embodiment of the present disclosure.
FIG. 19A is a cross-sectional view taken along line VII-VII' illustrated in FIG. 18A.
FIG. 19B is a cross-sectional view taken along line VIII-VIII' illustrated in FIG. 18A.
FIGS. 19C and 19D are cross-sectional views taken along line IX-IX' illustrated in FIG. 18B.
FIGS. 20A and 20B are perspective views for explaining an electronic device according to an embodiment of the present disclosure.
FIG. 21A is a cross-sectional view taken along line X-X' illustrated in FIG. 20A.
FIG. 21B is a cross-sectional view taken along line XI-XI' illustrated in FIG. 20A.
FIG. 21C is a cross-sectional view taken along line XII-XII' illustrated in FIG. 20B.
FIGS. 22A and 22B are perspective views for explaining an electronic device according to an embodiment of the present disclosure.

### DETAILED DESCRIPTION

The above and other aspects, features, and advantages of the present disclosure will become apparent from the following description of embodiments given in conjunction with the accompanying drawings. However, the present disclosure is not limited to the embodiments disclosed herein and may be implemented in various different forms. Herein, the embodiments are provided to provide complete disclosure of the present disclosure and to provide thorough understanding of the present disclosure to those skilled in the art to which the present disclosure pertains, and the scope of the present disclosure should be limited only by the accompanying claims and equivalents thereof. Like reference numerals refer to like elements throughout.

When one element or layer is referred to as being related to another element such as being "on" another element or layer, it can be directly on the other element or layer, or intervening elements or layers may be present. In contrast, when one element is referred to as being related to another element such as being "directly on" another element or layer, there are no intervening elements or layers present.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes each of mentioned items and all combinations of one or more of the items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "below", "beneath", "lower", "above", "upper" and the like, may be used to easily describe a correlation between one element or component and another element or component as illustrated in the drawings. The spatially relative terms should be understood as terms including different directions of an element during use or operation in addition to the direction illustrated in the drawings.

Although the terms "first," "second," and the like are used herein to describe various elements, components, and/or sections, these elements, components, and/or sections should not be limited by these terms. These terms are only used to distinguish one element, component, or section from another element, component, or section. Accordingly, a first element, a first component, or a first section mentioned below could be termed a second element, a second component, or a second section within the scope of the present disclosure.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Embodiments described herein will be described with reference to plan views and sectional views which are ideal schematic views of the present disclosure. Accordingly, the forms of illustrative drawings may be changed according to manufacturing technology and/or allowable errors. Embodiments of the present disclosure are not limited to specific forms illustrated, but include changes in the forms generated according to manufacturing processes. Regions illustrated in the drawings have schematic properties, and the shapes of the regions illustrated in the drawings illustrate specific forms of regions of devices and are not intended to limit the scope of the present disclosure.

Hereinafter, embodiments of the present disclosure will be described in more detail with reference to the accompanying drawings.

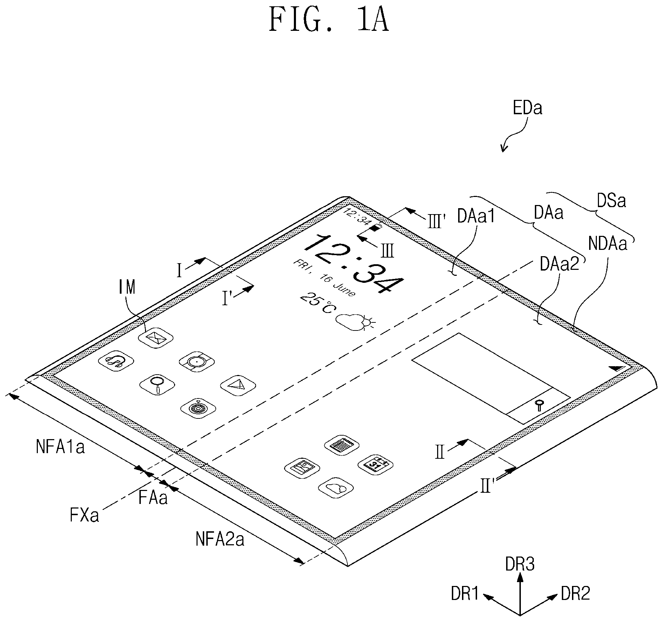

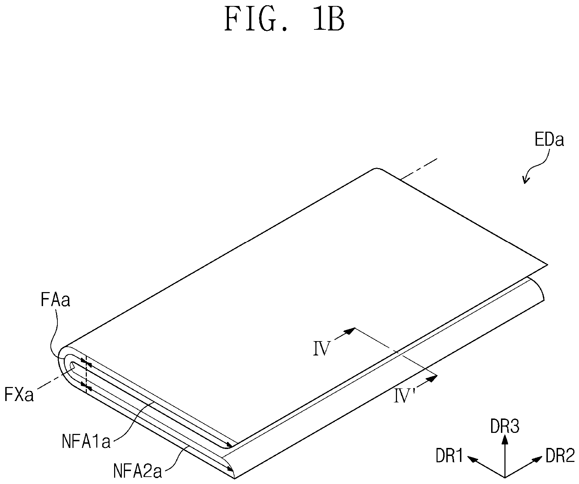

FIG. 1A is a perspective view of an electronic device Eda according to an embodiment of the present disclosure. FIG. 1B is a view illustrating a folded state of the electronic device Eda illustrated in FIG. 1A.

Referring to FIG. 1A, the electronic device EDa according to an embodiment of the present disclosure may have a rectangular shape with short sides extending in a first direction DR1, and long sides extending in a second direction DR2 crossing the first direction DR1. However, without being limited thereto, the electronic device EDa may have various planar shapes such as a circular shape, a polygonal shape, and the like. The electronic device EDa may be a flexible electronic device.

A plane may be defined by the first direction DR1 and the second direction DR2 which cross each other. A direction intersecting the first direction DR1 and the second direction DR2 may be a third direction DR3. A thickness of an electronic device Eda and various components or layers thereof may be defined along the third direction DR3 (e.g., a thickness direction). Hereinafter, a direction substantially perpendicular to a plane defined by the first direction DR1 and the second direction DR2 may be defined as a third direction DR3, without being limited thereto. Furthermore, the expression "when viewed from above the plane" used herein may mean a view along the third direction DR3.

The electronic device EDa may include a folding region FAa and a non-folding region provided in plural including a plurality of non-folding regions NFA1a and NFA2a. The non-folding regions NFA1a and NFA2a may include the first non-folding region NFA1a and the second non-folding region NFA2a. The folding region FAa may be disposed between the first non-folding region NFA1a and the second non-folding region NFA2a. The first non-folding region NFA1a, the folding region FAa, and the second non-folding region NFA2a may be arranged in the first direction DR1.

Although one folding region FAa and two non-folding regions NFA1a and NFA2a are illustrated as an example, the number of folding regions FAa and the number of non-folding regions NFA1a and NFA2a are not limited thereto. For example, the electronic device EDa may include more than two non-folding regions and a plurality of folding regions, each of which is disposed between the non-folding regions.

As used herein, the first non-folding region NFA1a may be defined as a first region NFA1a. The second non-folding region NFA2a may be defined as a second region NFA2a. The folding region FAa may be defined as a third region FAa.

An upper surface (or an outer surface) of the electronic device EDa may be defined as a display surface Dsa. The display surface DSa may be defined in or parallel to a plane defined by the first direction DR1 and the second direction DR2. An image IM generated by the electronic device EDa may be provided to outside the electronic device EDa, such as to a user of the electronic device EDa, through the display surface DSa.

The display surface DSa may include a display region DAa and a non-display region NDAa which is adjacent to the display region DAa. The non-display region NDAa may be extended around the display region DAa. The display region DAa may be defined as the front surface of the electronic device EDa. The display region DAa may display an image IM, and the non-display region NDAa may not display an image IM. The non-display region NDAa may surround the display region DAa in the plane view (e.g., a view along the third direction DR3) and may define the border of the electronic device EDa. The border may be a printed feature such as having a predetermined color.

The display region DAa may be divided into a first display region DAa1 and a second display region DAa2 with respect to a folding axis FXa. The first display region DAa1 may overlap the first region NFA1a. The second display region DAa2 may overlap the second region NFA2a.

Referring to FIGS. 1A and 1B, the electronic device EDa may be a foldable electronic device EDa which is folded or unfolded at the folding region FAa. For example, the folding region FAa may be bent about the folding axis FXa parallel to the second direction DR2, and the electronic device EDa may be folded accordingly with respect to the folding axis FXa.

Referring to FIGS. 1A and 1B, the electronic device EDa may have a sectional shape at opposing edge portions of the electronic device EDa. Edge portions of the first non-folding region NFA1a and the second non-folding region NFA2a may define these sectional shapes, such as along lines I-I' and II-II' which will be discussed later. The sectional shape defined at edge portions of the first non-folding region NFA1a and the second non-folding region NFA2a may may be maintained, even in the electronic device EDa which is folded at the folding region FAa.

When the electronic device EDa is folded, the first non-folding region NFA1a and the second non-folding region NFA2a may face each other along the thickness direction. The first display region DAa1 and the second display region DAa2 may face each other. The electronic device EDa may be in-folded such that portions of the display surface DSa face each other and are not exposed to the outside (e.g., outside of the electronic device EDa).

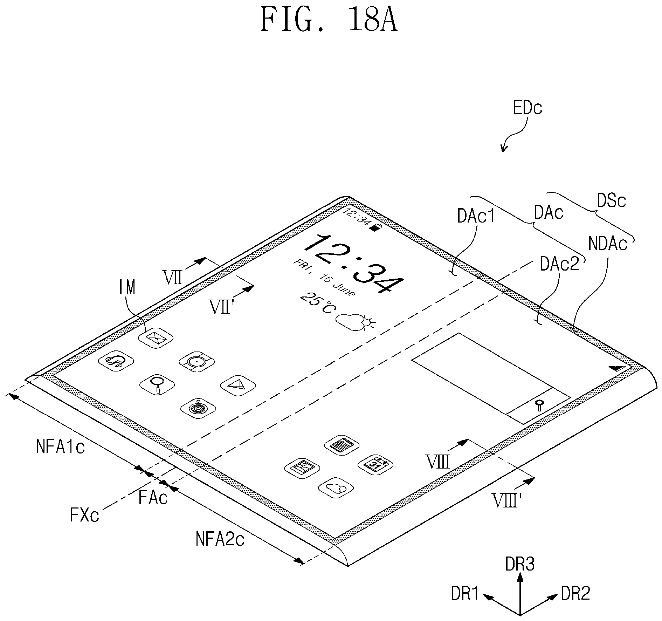

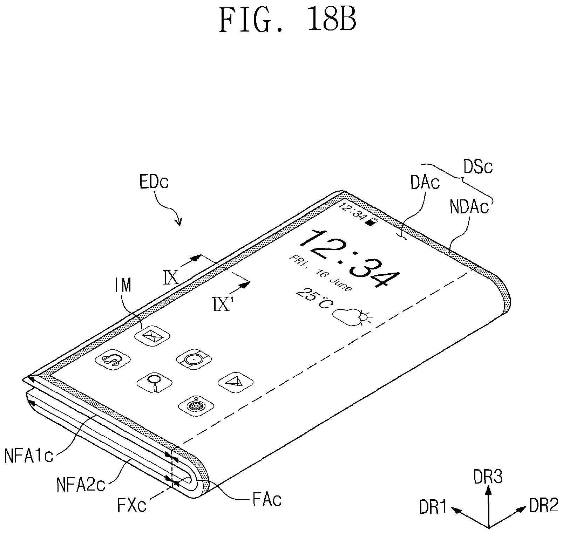

However, embodiments of the present disclosure are not limited thereto. For example, the electronic device EDa may be out-folded about the folding axis FXa. The out-folding will be described below in detail with reference to FIGS. 18A and 18B.

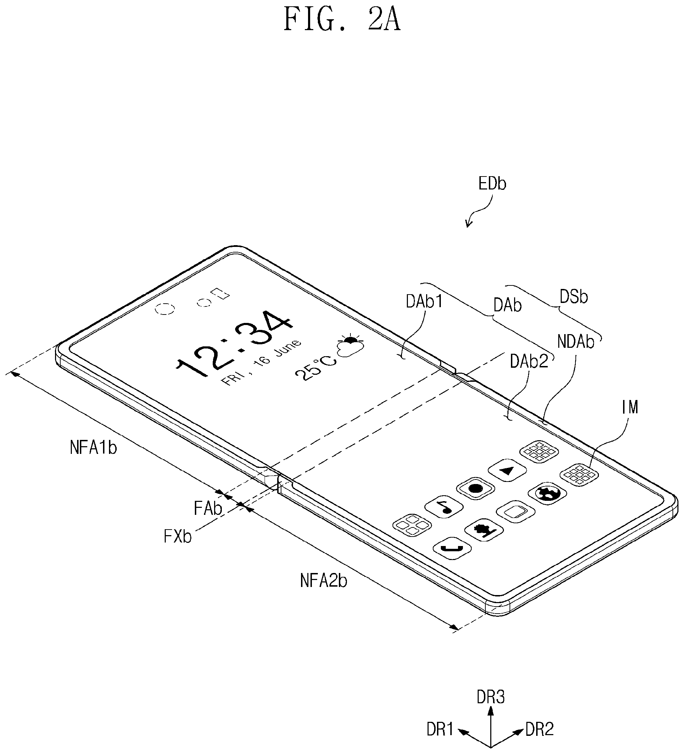

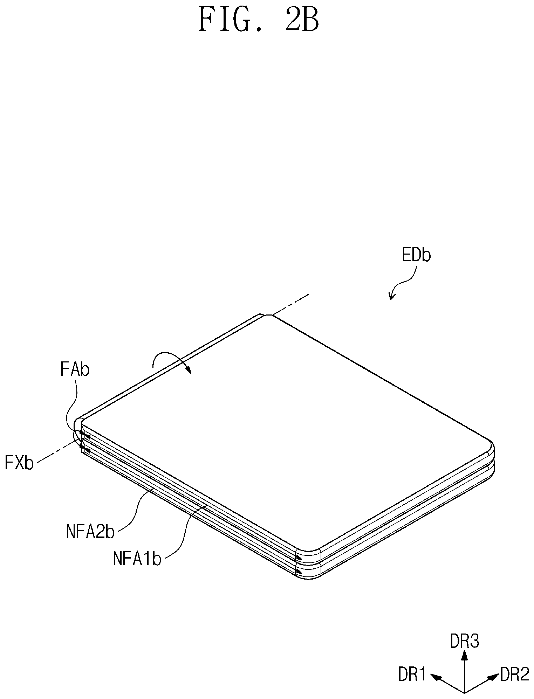

FIG. 2A is a perspective view of an electronic device EDb according to an embodiment of the present disclosure. FIG. 2B is a view illustrating a folded state of the electronic device EDb illustrated in FIG. 2A.

The following description will be focused on a difference between the electronic device EDb illustrated in FIGS. 2A and 2B and the electronic device EDa illustrated in FIGS. 1A and 1B.

Referring to FIGS. 2A and 2B, the electronic device EDb according to an embodiment of the present disclosure may have a rectangular shape with long sides extending in the first direction DR1 and short sides extending in the second direction DR2.

A folding region FAb may be disposed between a first non-folding region NFA1b and a second non-folding region NFA2b. The first non-folding region NFA1b, the folding region FAb, and the second non-folding region NFA2b may be arranged in the first direction DR1.

As used herein, the first non-folding region NFA1b may be defined as the first region NFA1b. The second non-folding region NFA2b may be defined as the second region NFA2b. The folding region FAb may be defined as the third region FAb.

The electronic device EDb may be a foldable electronic device EDb which is folded or unfolded. The folding region FAb may be bent about a folding axis FXb parallel to the second direction DR2, and the electronic device EDb may be folded accordingly. The folding axis FXb may be defined as an axis parallel to the short sides.

An upper surface of the electronic device EDb may be defined as a display surface DSb, and the display surface DSb may have a plane defined by the first direction DR1 and the second direction DR2. Images IM generated by the electronic device EDb may be provided to a user through the display surface DSb.

The display surface DSb may include a display region DAb and a non-display region NDAb which is around the display region DAb. The display region DAb may be defined as the front surface of the electronic device EDb. The display region DAb may display an image IM, and the non-display region NDAb may not display an image IM.

The display region DAb may be divided into a first display region DAb1 and a second display region DAb2 with respect to the folding axis FXb. The first display region DAb1 may overlap the first region NFA1b. The second display region DAb2 may overlap the second region NFA2b.

When the electronic device EDb is folded, the first non-folding region NFA1b and the second non-folding region NFA2b may face each other. The first display region DAb1 and the second display region DAb2 may face each other. The electronic device EDb may be in-folded such that the display surface DSb is not exposed to the outside.

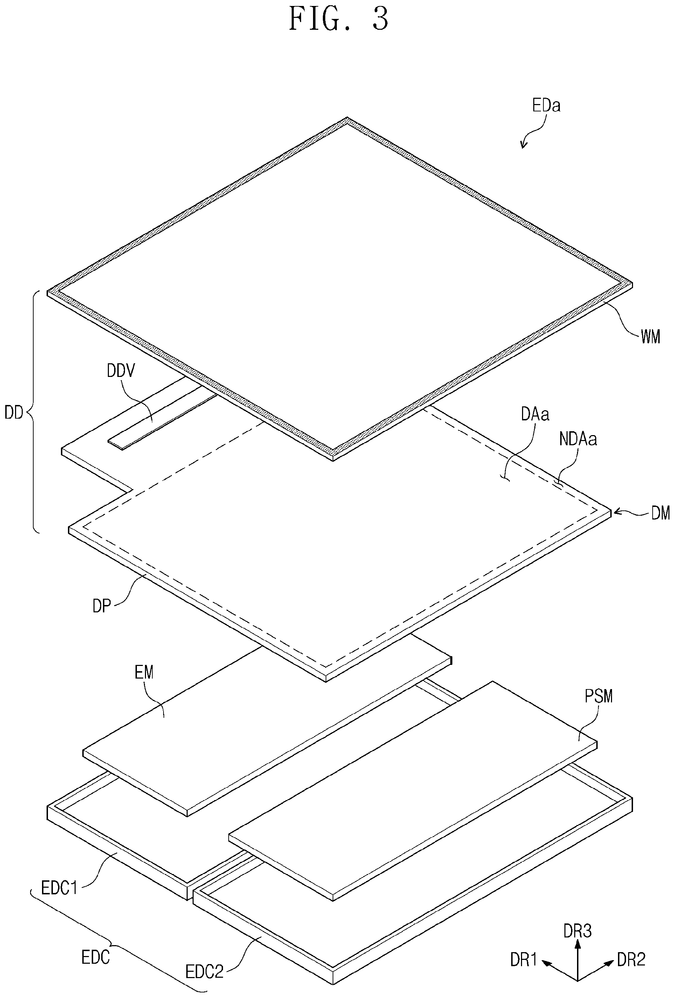

FIG. 3 is an exploded perspective view of the electronic device EDa illustrated in FIGS. 1A and 1B.

The exploded perspective view of the electronic device EDa illustrated in FIGS. 1A and 1B will be described with reference to FIG. 3. However, without being limited thereto, the electronic device EDb illustrated in FIGS. 2A and 2B may also have a bracket EDC having substantially the same configuration except for the extension direction of the long sides and the extension direction of the short sides.

Referring to FIG. 3, the electronic device EDa may include a display device DD, an electronic module EM, a power supply module PSM, and a bracket EDC. Although not illustrated, the electronic device EDa may further include a mechanical structure (e.g., a hinge) for controlling a folding operation of the display device DD. One or more components of the electronic device EDa may be foldable, rollable, bendable, etc. together with each other.

The display device DD may generate an image IM and may sense an external input. The display device DD may include a window module WM and a display module DM. The window module WM may provide the front surface of the electronic device EDa. The window module WM may be disposed on the display module DM and may protect the display module DM. The window module WM may transmit light generated from the display module DM and may provide the light to outside of the electronic device EDa, such as to a user.

The display module DM may include a display panel DP. Although only the display panel DP among stacked structures of the display module DM is illustrated in FIG. 3, the display module DM may substantially further include a plurality of components disposed on and/or under the display panel DP. A detailed stacked structure of the display module DM will be described below in detail. The display panel DP may include a display region DAa and a non-display region NDAa which correspond to the display region DAa and the non-display region NDAa of the electronic device EDa of FIG. 1A, respectively.

The display module DM may include a data driver DDV disposed on the non-display region NDAa of the display panel DP. The data driver DDV may be manufactured in the form of an integrated circuit chip and may be mounted on the non-display region NDAa. However, without being limited thereto, the data driver DDV may be mounted on a flexible circuit board connected to the display panel DP.

The electronic module EM and the power supply module PSM may be disposed under the display device DD. Although not illustrated, the electronic module EM and the power supply module PSM may be connected with each other through a separate flexible circuit board. The electronic module EM may control operations of the display device DD. The power supply module PSM may supply power to the electronic module EM.

The bracket EDC may accommodate the display device DD, the electronic module EM, and the power supply module PSM. To fold the display device DD, the bracket EDC may include a first case EDC1 and a second case EDC2. The first and second cases EDC1 and EDC2 may extend to have a major dimension in (or along) the second direction DR2 and may be arranged adjacent to each other in (or along) the first direction DR1. The cases may together form a housing.

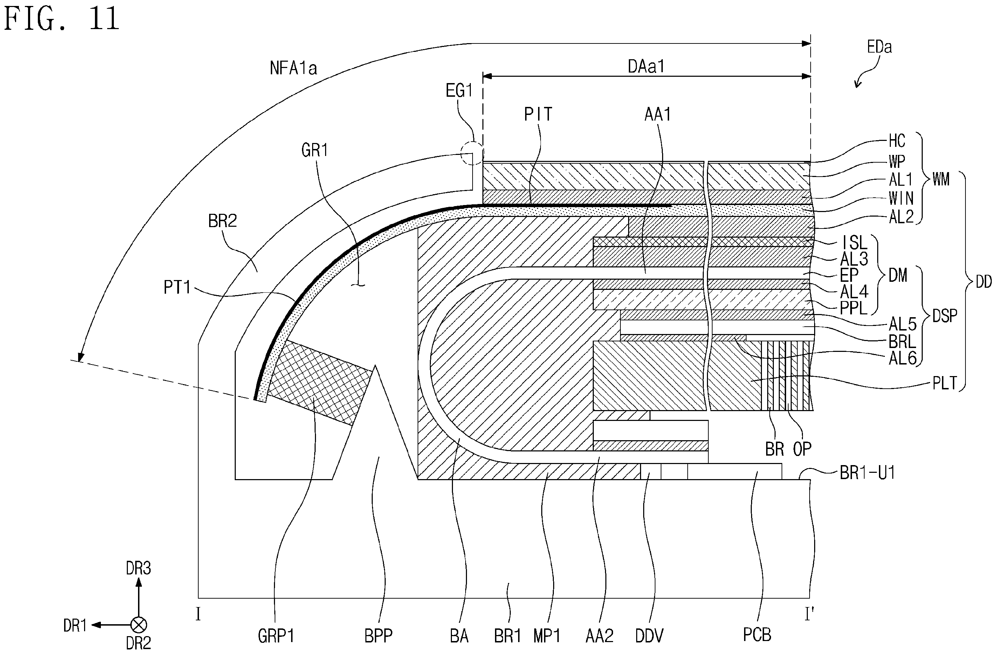

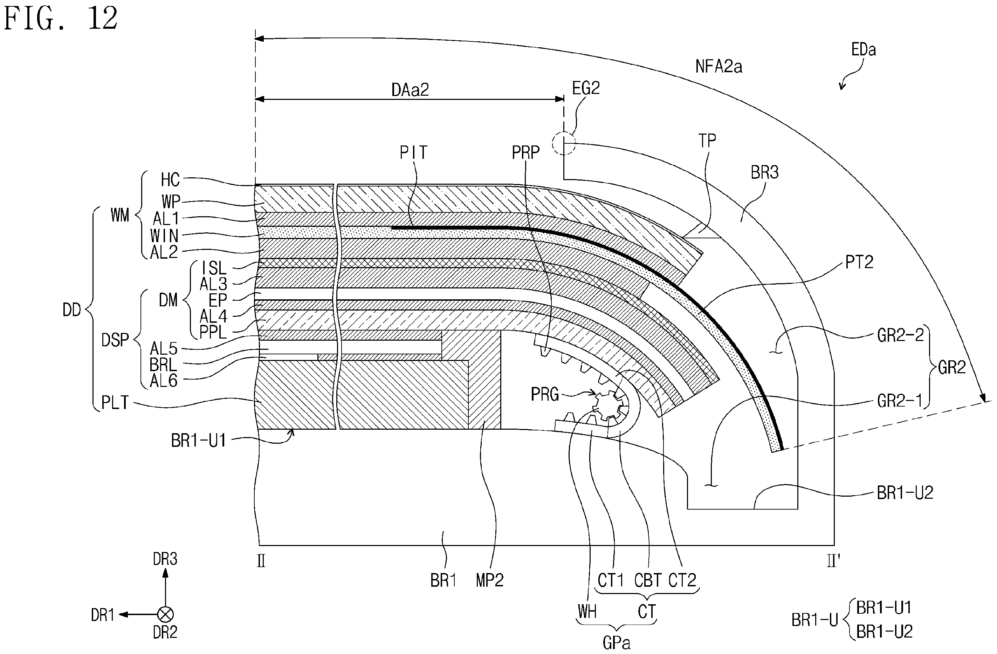

Edges of sections obtained by cutting the first and second cases EDC1 and EDC2 in the first direction DR1 may have different cross-sectional shapes from each other. Detailed description thereabout will be given below with reference to FIGS. 11 and 12. Each of the first and second cases EDC1 and EDC2 may include a first side (e.g., one side) and a second side which opposes the first side (e.g., an opposite side).

Although not illustrated, the electronic device EDa may further include a hinge structure for connecting the first and second cases EDC1 and EDC2 to each other. The bracket EDC may be coupled with the window module WM. The bracket EDC may protect the display device DD, the electronic module EM, and the power supply module PSM. The bracket EDC together with the window module WM may form an outer surface or outer appearance of the electronic device EDa.

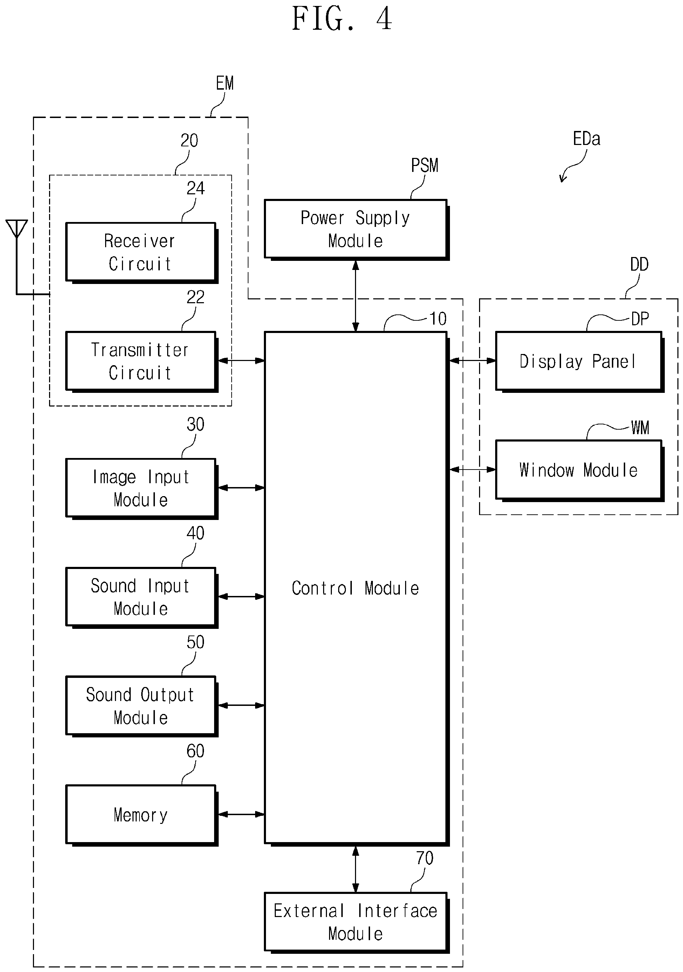

FIG. 4 is a block diagram of the electronic device EDa illustrated in FIG. 3.

Referring to FIG. 4, the electronic device EDa may include the electronic module EM, the power supply module PSM, and the display device DD. The electronic module EM may include a control module 10, a wireless communication module 20, an image input module 30, a sound input module 40, a sound output module 50, a memory 60, and an external interface module 70. The modules may be mounted on a circuit board, or may be electrically connected through a flexible circuit board. The electronic module EM may be electrically connected with the power supply module PSM.

The control module 10 may control overall operation of the electronic device EDa. For example, the control module 10 may activate or deactivate the display device DD in response to an input, such as to a user input. The control module 10 may control the image input module 30, the sound input module 40, and the sound output module 50 in response to a user input. The control module 10 may include at least one microprocessor.

The wireless communication module 20 may transmit/receive wireless signals with other terminals through Bluetooth or Wi-Fi. The wireless communication module 20 may transmit/receive sound signals using a general communication line. The wireless communication module 20 may include a transmitter circuit 22 which modulates a signal to be transmitted and transmits the modulated signal and a receiver circuit 24 which demodulates a received signal.

The image input module 30 may process an image signal to covert the image signal into image data which can be displayed on the display device DD. The sound input module 40 may receive an external sound signal through a microphone in a voice recording mode or a voice recognition mode and may convert the external sound signal into electrical voice data. The sound output module 50 may convert sound data received from the wireless communication module 20 or sound data stored in the memory 60 and may output the converted sound data to the outside.

The external interface module 70 may serve as an interface connected to an external charger, a wired/wireless data port, or a card socket (e.g., a memory card or a SIM/UIM card).

The power supply module PSM may supply power required for overall operation of the electronic device EDa. The power supply module PSM may include a conventional battery device.

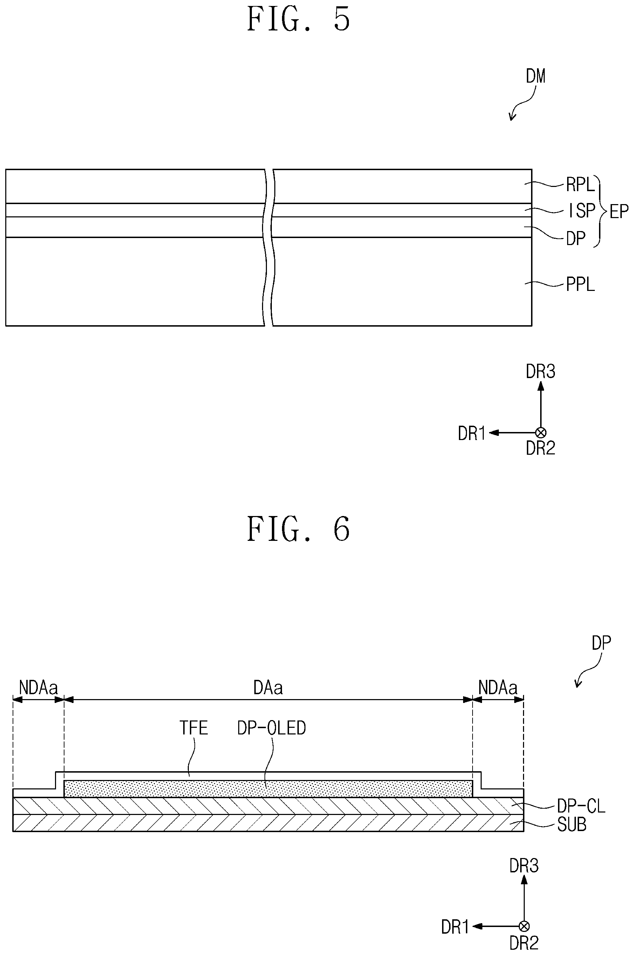

FIG. 5 is a schematic sectional view of the display module DM illustrated in FIG. 3.

Referring to FIG. 5, the display module DM may include the display panel DP, an input sensing unit ISP disposed on the display panel DP, an anti-reflection layer RPL disposed on the input sensing unit ISP, and a panel protection layer PPL disposed under the display panel DP. The display panel DP may be a flexible display panel. For example, the display panel DP may include a flexible substrate and a plurality of elements disposed on the flexible substrate.

The display panel DP according to an embodiment of the present disclosure may be an emissive display panel, but is not particularly limited. For example, the display panel DP may be an organic light emitting display panel or an inorganic light emitting display panel. An emissive layer of the organic light emitting display panel may include an organic light emitting material. An emissive layer of the inorganic light emitting display panel may include quantum dots, quantum rods, and the like. Hereinafter, it will be exemplified that the display panel DP is an organic light emitting display panel.

The input sensing unit ISP as a sensing layer may include a plurality of sensor units (not illustrated) for sensing an external input in a capacitive type. The input sensing unit ISP may be directly formed (or provided) on the display panel DP when the display module DM is manufactured.

The anti-reflection layer RPL as a functional layer may be disposed on the input sensing unit ISP. The anti-reflection layer RPL may be directly formed on the input sensing unit ISP when the display module DM is manufactured. The anti-reflection layer RPL may be defined as a film (or layer) for preventing reflection of external light. The anti-reflection layer RPL may decrease the reflectance of external light incident toward the display panel DP from above the display device DD.

For example, the input sensing unit ISP may be directly formed on the display panel DP, and the anti-reflection layer RPL may be directly formed on the input sensing unit ISP. However, embodiments of the present disclosure are not limited thereto. For example, the input sensing unit ISP may be separately manufactured and may be attached to the display panel DP by an intervening layer such as an adhesive layer, and the anti-reflection layer RPL may be separately manufactured and may be attached to the input sensing unit ISP by an intervening layer such as an adhesive layer.

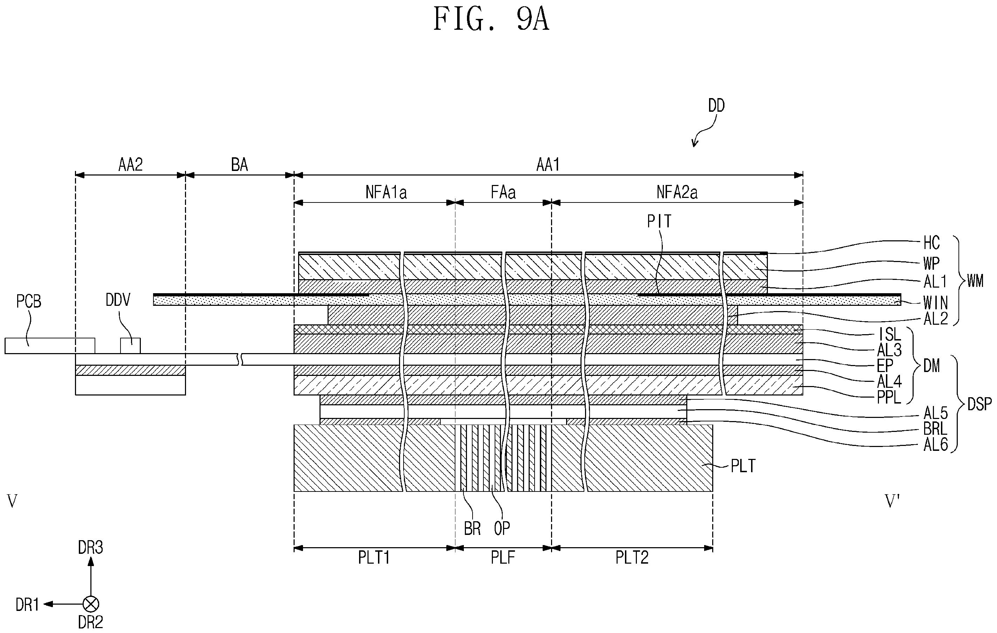

The display panel DP, the input sensing unit ISP, and the anti-reflection layer RPL may together be defined as an electronic panel EP (refer to FIG. 9A).

The panel protection layer PPL may be disposed under the display panel DP. The panel protection layer PPL may protect the bottom of the display panel DP. The panel protection layer PPL may include a flexible plastic material. For example, the panel protection layer PPL may include polyethylene terephthalate (PET).

FIG. 6 is a cross-sectional view of the display panel DP illustrated in FIG. 5.

In FIG. 6, a cross-section of the display panel DP viewed in the second direction DR2 is illustrated.

Referring to FIG. 6, the display panel DP may include a substrate SUB, a circuit element layer DP-CL disposed on the substrate SUB, a display element layer DP-OLED disposed on the circuit element layer DP-CL, and a thin film encapsulation layer TFE as an encapsulation layer disposed on the display element layer DP-OLED.

The substrate SUB may include a display region DAa and a non-display region NDAa which is around the display region DAa. The substrate SUB may include a flexible plastic material such as glass or polyimide (PI). The display element layer DP-OLED may be disposed on the display region DAa.

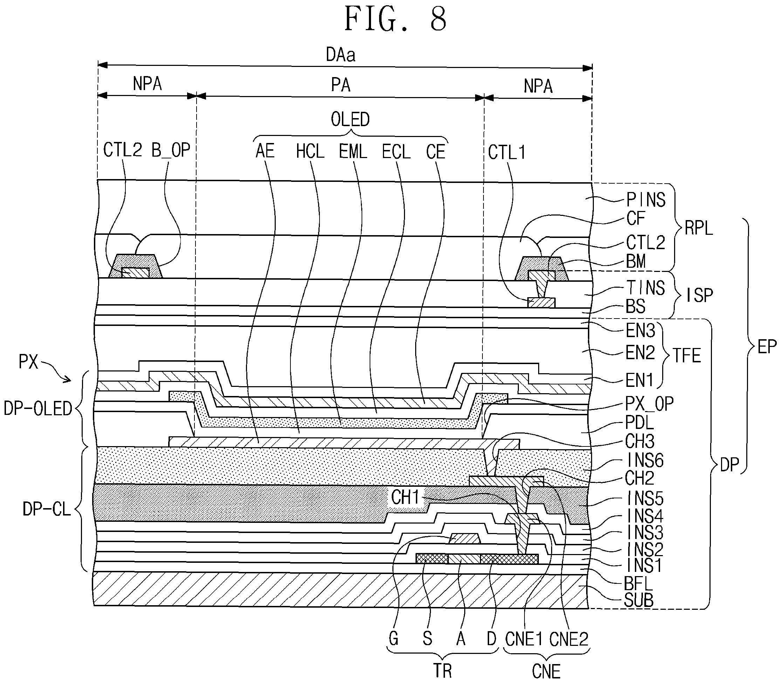

A plurality of pixels PX may be disposed in the circuit element layer DP-CL and the display element layer DP-OLED. Each of the pixels PX may include transistors disposed in the circuit element layer DP-CL and a light emitting element OLED which is disposed in the display element layer DP-OLED and connected to one or more among the transistors. The configuration of the pixel PX will be described below in detail with reference to FIG. 8.

The thin film encapsulation layer TFE may be disposed on the circuit element layer DP-CL to cover the display element layer DP-OLED. The thin film encapsulation layer TFE may protect the pixels PX from moisture, oxygen, and external foreign matter.

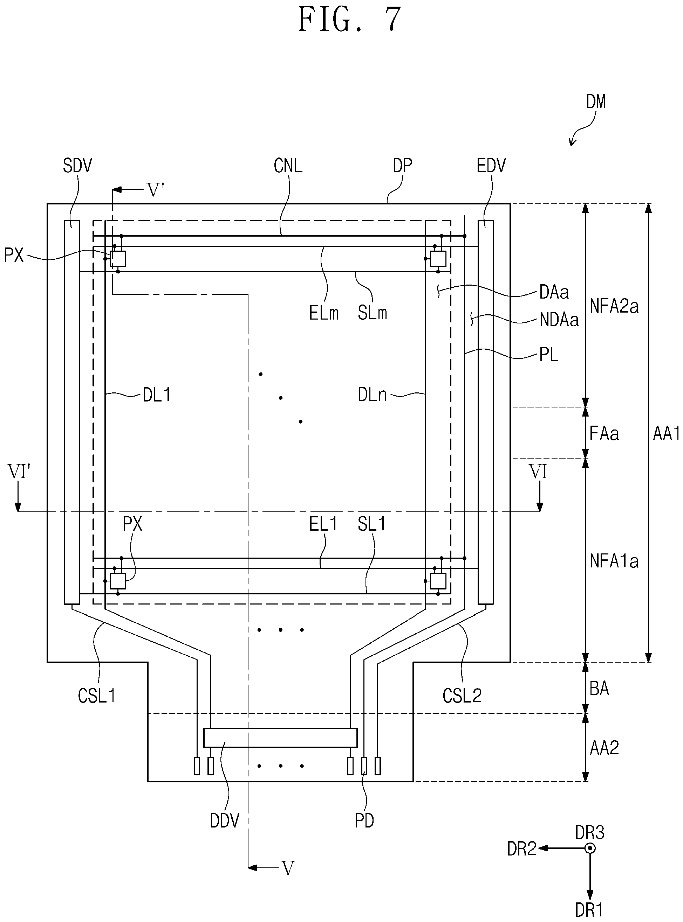

FIG. 7 is a cross-sectional view of the display panel DP illustrated in FIG. 3.

Referring to FIG. 7, the display module DM may include the display panel DP, a scan driver SDV, the data driver DDV, and an emission driver EDV.

The display panel DP may include a first panel portion AA1, a second panel portion AA2, and a bending portion BA between the first panel portion AA1 and the second panel portion AA2. The bending portion BA may extend in the second direction DR2 (e.g., have a major dimension in the second direction DR2). The first panel portion AA1, the bending portion BA, and the second panel portion AA2 may be arranged in order in the first direction DR1.

The first panel portion AA1 may include a display region DAa and a non-display region NDAa which is around the display region DAa. The non-display region NDAa may surround the display region DAa in the plan view. The display region DAa may be a region which displays an image IM, and the non-display region NDAa may be a region which does not display an image IM. The second panel portion AA2 and the bending portion BA may be regions which do not display an image IM. That is, the second panel portion AA2 and the bending portion BA may be planar areas in an overall planar area of the non-display region NDAa.

The first panel portion AA1, when viewed in the second direction DR2, may include a first non-folding region NFA1a (or, a first region), a second non-folding region NFA2a (or, a second region), and a folding region FAa (or, a third region) between the first non-folding region NFA1a and the second non-folding region NFA2a.

The display panel DP may include a plurality of pixels PX, a plurality of scan lines SL1 to SLm, a plurality of data lines DL1 to DLn, a plurality of emission lines EL1 to ELm, first and second control lines CSL1 and CSL2, a power line PL, a plurality of connecting lines CNL, and a plurality of pads PD. As used herein, "m" and "n" are natural numbers. The pixels PX may be disposed in the display region DAa and may be variously connected to the scan lines SL1 to SLm, the data lines DL1 to DLn, and the emission lines EL1 to ELm as signal lines (or conductive lines) which transmit one or more electrical signal therethrough.

The scan driver SDV and the emission driver EDV may be disposed in the non-display region NDAa. The scan driver SDV and the emission driver EDV may be respectively disposed in portions of the non-display regions NDAa which are at opposite sides of the first panel portion AA1 along the second direction DR2. The data driver DDV may be disposed on the second panel portion AA2, at a distal end of the display panel DP. The data driver DDV may be manufactured in the form of an integrated circuit chip and may be mounted on the display panel DP, at the second panel portion AA2.

The scan lines SL1 to SLm may extend in the second direction DR2 and may be connected to the scan driver SDV. The data lines DL1 to DLn may extend in the first direction DR1 and may be connected to the data driver DDV via conductive lines in the bending portion BA. The emission lines EL1 to ELm may extend in the second direction DR2 and may be connected to the emission driver EDV.

The power line PL may extend in the first direction DR1 and may be disposed in the non-display region NDAa. The power line PL may be disposed between the display region DAa and the emission driver EDV in the plan view. However, without being limited thereto, the power line PL may be disposed between the display region DAa and the scan driver SDV.

The power line PL may extend to the second panel portion AA2 via the bending portion BA. The power line PL may extend toward a lower end (e.g., the distal end) of the second panel portion AA2 when viewed from above the plane. The power line PL may receive a drive voltage.

The connecting lines CNL may extend in the second direction DR2 and may be arranged in the first direction DR1. The connecting lines CNL may be variously connected to the power line PL and the pixels PX. The drive voltage may be applied to the pixels PX through the power line PL and the connecting lines CNL connected with each other.

The first control line CSL1 may be connected to the scan driver SDV and may extend toward the lower end of the second panel portion AA2 via the bending portion BA. The data driver DDV may be disposed between the first control line CSL1 and the second control line CSL2.

A pad PD may be provided in plural including the pads PD disposed adjacent to the lower end of the second panel portion AA2 when viewed from above the plane. The data driver DDV, the power line PL, the first control line CSL1, and the second control line CSL2 may be variously connected to the pads PD.

The data lines DL1 to DLn may be connected to the corresponding pads PD through the data driver DDV. For example, the data lines DL1 to DLn may be connected to the data driver DDV, and the data driver DDV may be connected to the pads PD corresponding to the data lines DL1 to DLn.

Although not illustrated, a printed circuit board PCB may be connected to the display panel DP, via the pads PD, and a timing controller and a voltage generator may be disposed on the printed circuit board PCB. The timing controller may be manufactured in the form of an integrated circuit chip and may be mounted on the printed circuit board PCB. The timing controller and the voltage generator may be connected to the pads PD, through the printed circuit board PCB.

The timing controller may control operations of the scan driver SDV, the data driver DDV, and the emission driver EDV. The timing controller may generate a scan control signal, a data control signal, and an emission control signal as various electrical signals, in response to control signals received from the outside. The voltage generator may generate the drive voltage.

The scan control signal may be provided to the scan driver SDV through the first control line CSL1. The emission control signal may be provided to the emission driver EDV through the second control line CSL2. The data control signal may be provided to the data driver DDV. The timing controller may receive image signals from the outside, may convert the data format of the image signals according to the specification of an interface with the data driver DDV, and may provide the converted signals to the data driver DDV.

The scan driver SDV may generate a plurality of scan signals in response to the scan control signal. The scan signals may be applied to the pixels PX through the scan lines SL1 to SLm. The scan signals may be sequentially applied to the pixels PX.

The data driver DDV may generate a plurality of data voltages corresponding to the image signals in response to the data control signal. The data voltages may be applied to the pixels PX through the data lines DL1 to DLn. The emission driver EDV may generate a plurality of emission signals in response to the emission control signal. The emission signals may be applied to the pixels PX through the emission lines EL1 to ELm.

The pixels PX may receive the data voltages in response to the scan signals. The pixels PX may display an image IM by emitting light having luminance corresponding to the data voltages in response to the emission signals. The light emission time of the pixels PX may be controlled by the emission signals.

FIG. 8 is a cross-view illustrating a section of the electronic panel EP corresponding to any one pixel PX illustrated in FIG. 7.

Referring to FIG. 8, the pixel PX may include a transistor TR and a light emitting element OLED. The light emitting element OLED may include a first electrode AE (or, an anode), a second electrode CE (or, a cathode) facing the first electrode AE, a hole control layer HCL, an electron control layer ECL, and an emissive layer EML as a light emissive layer.

The transistor TR and the light emitting element OLED may be disposed on the substrate SUB. Although one transistor TR is illustrated as an example, the pixel PX may substantially include a plurality of transistors and at least one capacitor for driving the light emitting element OLED.

The display region DAa may include an emissive region PA as a light emission area corresponding to each of the pixels PX and a non-emissive region NPA which is adjacent to the emission region PA such as being around the emissive region PA, in the plan view. The light emitting element OLED may be disposed in the emissive region PA.

A buffer layer BFL may be disposed on the substrate SUB. The buffer layer BFL may be an inorganic layer. A semiconductor pattern may be disposed on the buffer layer BFL. The semiconductor pattern may include poly silicon, amorphous silicon, or metal oxide.

The semiconductor pattern may be doped with an N-type dopant or a P-type dopant. The semiconductor pattern may include a heavily doped region and a lightly doped region. The heavily doped region may have a higher conductivity (e.g., electrical conductivity) than the lightly doped region and may substantially serve as a source electrode and a drain electrode of the transistor TR. The lightly doped region may substantially correspond to an active (or, channel) region of the transistor.

The source S, the active region A, and the drain D of the transistor TR may be formed from the semiconductor pattern, such as corresponding to the source electrode, the active region and the drain electrode described above. A first insulating layer INS1 may be disposed on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

To connect the transistor TR and the light emitting element OLED which are in different layers, to each other, a connecting electrode CNE may include a first connecting electrode CNE1 and a second connecting electrode CNE2. The first connecting electrode CNE1 as a lower connecting electrode may be disposed on the third insulating layer INS3 and may be connected to the drain D through (or at) a first contact hole CH1 defined in the first to third insulating layers INS1 to INS3. Here, one or more insulating layer like the first to third insulating layers INS1 to INS3 may be collectively referred to as "an insulating layer."

A fourth insulating layer INS4 may be disposed on the first connecting electrode CNE1. A fifth insulating layer INS5 may be disposed on the fourth insulating layer INS4. The second connecting electrode CNE2 as an upper connecting electrode may be disposed on the fifth insulating layer INS5. The second connecting electrode CNE2 may be connected (e.g., electrically connected) to the first connecting electrode CNE1 and form the connecting electrode CNE, through a second contact hole CH2 defined in the fourth and fifth insulating layers INS4 and INS5.

A sixth insulating layer INS6 may be disposed on the second connecting electrode CNE2. The layers from the buffer layer BFL to the sixth insulating layer INS6, inclusive, may be defined as the circuit element layer DP-CL. The first to sixth insulating layers INS1 to INS6 may be inorganic layers or organic layers.

The first electrode AE may be disposed on the sixth insulating layer INS6. The first electrode AE may be electrically connected to the second connecting electrode CNE2, through a third contact hole CH3 defined in the sixth insulating layer INS6.

A pixel defining layer PDL having an opening PX_OP (e.g., a pixel opening) defined therein to expose a predetermined portion of the first electrode AE to outside the pixel defining layer PDL, may be disposed on the first electrode AE and the sixth insulating layer INS6. The pixel opening may define the emissive region PA, where each of the pixel opening an the emissive region PA may have a planar area defined along a plane.

The hole control layer HCL may be disposed on the first electrode AE and the pixel defining layer PDL. The hole control layer HCL may include a hole transport layer and a hole injection layer.

The emissive layer EML may be disposed on the hole control layer HCL. The emissive layer EML may be disposed in a region corresponding to the opening PX_OP. The emissive layer EML may include an organic material and/or an inorganic material. The emissive layer EML may generate one of red light, green light, and blue light. The first electrode AE and the emissive layer EML may be discretely disposed in the light emission region, such as a discrete pattern.

The electron control layer ECL may be disposed on the emissive layer EML and the hole control layer HCL. The electron control layer ECL may include an electron transport layer and an electron injection layer. The hole control layer HCL and the electron control layer ECL may be commonly disposed in the emissive region PA and the non-emissive region NPA.

The second electrode CE may be disposed on the electron control layer ECL. The second electrode CE may be commonly disposed in the pixels PX. The layer in which the light emitting element OLED is disposed may be defined as the display element layer DP-OLED.

The thin film encapsulation layer TFE may be disposed on the second electrode CE and may cover the pixel PX. The thin film encapsulation layer TFE may include a first encapsulation layer EN1 disposed on the second electrode CE, a second encapsulation layer EN2 disposed on the first encapsulation layer EN1, and a third encapsulation layer EN3 disposed on the second encapsulation layer EN2.

The first and third encapsulation layers EN1 and EN3 may include inorganic insulating layers and may protect the pixel PX from moisture/oxygen. The second encapsulation layer EN2 may include an organic insulating layer and may protect the pixel PX from foreign matter such as dust particles.

A first voltage may be applied to the first electrode AE through the transistor TR, and a second voltage having a lower level than the first voltage may be applied to the second electrode CE. Holes and electrons injected into the emissive layer EML may be combined to form excitons, and as the excitons transition to a ground state, the light emitting element OLED may emit light.

The input sensing unit ISP may be disposed on the thin film encapsulation layer TFE. The input sensing unit ISP may be directly manufactured on the upper surface of the thin film encapsulation layer TFE.

A base layer BS may be disposed on the thin film encapsulation layer TFE. The base layer BS may include an inorganic insulating layer. At least one inorganic insulating layer may be provided on the thin film encapsulation layer TFE as the base layer BS.

The input sensing unit ISP may include a first conductive pattern CTL1 and a second conductive pattern CTL2 which is disposed over the first conductive pattern CTL1. The first conductive pattern CTL1 may be disposed on the base layer BS. An insulating layer TINS may be disposed on the base layer BS to cover the first conductive pattern CTL1. The insulating layer TINS may include an inorganic insulating layer or an organic insulating layer. The second conductive pattern CTL2 may be disposed on the insulating layer TINS.

The first and second conductive patterns CTL1 and CTL2 may overlap the non-emissive region NPA. Although not illustrated, the first and second conductive patterns CTL1 and CTL2 may be disposed in the non-emissive region NPA between adjacent emissive regions PA and may have a mesh shape. As a mesh shape, material portions of a conductive layer may be spaced apart from each other with a gap therebetween, where the material portions and the gaps form the mesh shape.

The first and second conductive patterns CTL1 and CTL2 may form the above-described sensors of the input sensing unit ISP. For example, the first and second conductive patterns CTL1 and CTL2 having a mesh shape may be separated from each other in a predetermined region to form the sensors. A portion of the second conductive pattern CTL2 may be connected to the first conductive pattern CTL1, such as being electrically connected to each other.

The anti-reflection layer RPL may be disposed on the second conductive pattern CTL2. The anti-reflection layer RPL may include a black matrix BM and a plurality of color filters CF. The black matrix BM may overlap the non-emissive region NPA, and the color filters CF may overlap the emissive regions PA, respectively.

The black matrix BM may be disposed on the insulating layer TINS to cover the second conductive pattern CTL2. An opening B_OP overlapping the emissive region PA and the opening PX_OP may be defined by the black matrix BM to provide a light blocking layer including the black matrix BM and the opening B_OP therebetween. The black matrix BM may absorb and block light. The width of the opening B_OP may be greater than the width of the opening PX_OP. As used herein, the width may be taken in one or more planar direction, such as along the plane defined by the first direction DR1 and the second direction DR2 crossing each other.

The color filters CF may be disposed on the insulating layer TINS and the black matrix BM. The color filters CF may be disposed in the openings B_OP, respectively. A planarization insulating layer PINS may be disposed on the color filters CF. The planarization insulating layer PINS may provide a flat upper surface of the stacked structure forming the electronic panel EP.

When external light travelling toward the display panel DP is reflected from the display panel DP and provided back to the user, the user may visually recognize the external light as in a mirror. To prevent such a phenomenon, for example, the anti-reflection layer RPL may include the plurality of color filters CF which display the same colors as those of the pixels PX of the display panel DP. The color filters CF may filter the external light into the same colors as those of the pixels PX. In this case, the external light may not be visible to the user.

However, embodiments of the present disclosure are not limited thereto, and the anti-reflection layer RPL may include a polarizer film to decrease the reflectance of external light. The polarizer film may be separately manufactured and may be attached to the input sensing unit ISP by an adhesive layer. The polarizer film may include a phase retarder and/or a polarizer.

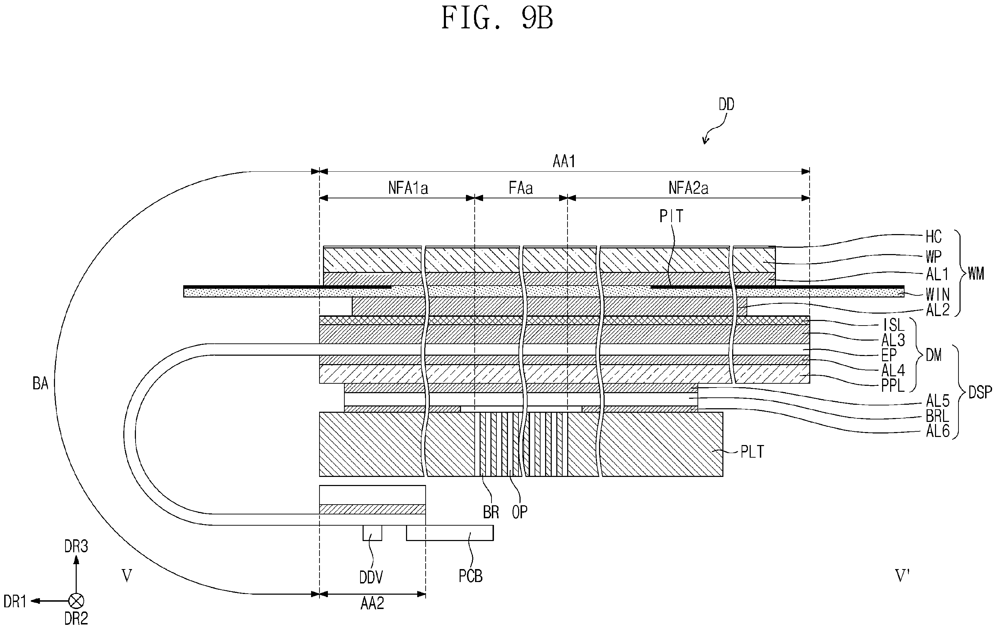

FIG. 9A is a cross-sectional view taken along line V-V' illustrated in FIG. 7. FIG. 9B is a view illustrating a state in which the bending portion BA illustrated in FIG. 9A is bent.

FIG. 9A is a view illustrating a portion of a display unit DSP, a portion of a support plate PLT, and a portion of the window module WM.

FIGS. 9A and 9B are cross-sectional views of the display device DD as viewed in the second direction DR2.

Referring to FIG. 9A, the display device DD may include the display unit DSP, the window module WM disposed on the display unit DSP, and the support plate PLT disposed under the display unit DSP. The support plate PLT may support the display module DM. The window module WM may include a window WIN, a window protection layer WP, a hard coating layer HC, and first and second adhesive layers AL1 and AL2.

The display unit DSP may include the electronic panel EP, an impact absorbing layer ISL, the panel protection layer PPL, a barrier layer BRL, and third to sixth adhesive layers AL3 to AL6. The impact absorbing layer ISL, the electronic panel EP, the panel protection layer PPL, the third adhesive layer AL3, and the fourth adhesive layer AL4 may be defined as the display module DM. The configurations of the electronic panel EP and the panel protection layer PPL have been described above in detail with reference to FIG. 5, and therefore description thereabout will be omitted.

The impact absorbing layer ISL may be disposed on the electronic panel EP. The impact absorbing layer ISL may protect the electronic panel EP by absorbing an external impact applied toward the electronic panel EP from above the display device DD. The impact absorbing layer ISL may be manufactured in the form of a stretchable film.

The impact absorbing layer ISL may include a flexible plastic material. The flexible plastic material may be defined as a synthetic resin film. For example, the impact absorbing layer ISL may include a flexible plastic material such as polyimide (PI) or polyethylene terephthalate (PET).

The window WIN may be disposed on the impact absorbing layer ISL. The window WIN may protect the electronic panel EP from external scratches. The window WIN may have a property of being optically clear. The window WIN may include glass. However, without being limited thereto, the window WIN may include a synthetic resin film.

The window WIN may have a multi-layer structure or a single-layer structure. For example, the window WIN may include a plurality of synthetic resin films coupled by an adhesive, or may include a glass substrate and a synthetic resin film coupled by an adhesive.

The window protection layer WP may be disposed on the window WIN. The window protection layer WP may include a flexible plastic material such as polyimide or polyethylene terephthalate. The hard coating layer HC may be disposed on the upper surface of the window protection layer WP.

A printed layer PIT may be disposed on the window WIN. The printed layer PIT may be black in color and may define a light blocking pattern. However, the color of the printed layer PIT is not limited thereto. The printed layer PIT may be adjacent to the periphery of the window WIN.

The barrier layer BRL may be disposed under the panel protection layer PPL. The barrier layer BRL may increase resistance to a compressive force caused by external pressing. Accordingly, the barrier layer BRL may serve to prevent deformation of the electronic panel EP. The barrier layer BRL may include a flexible plastic material such as polyimide or polyethylene terephthalate.

The barrier layer BRL may have a color which absorbs light. For example, the barrier layer BRL may be black in color. In this case, components disposed under the barrier layer BRL may not be visible when the display module DM is viewed from above the display module DM.

The first adhesive layer AL1 may be disposed between the window protection layer WP and the window WIN. The window protection layer WP and the window WIN may be bonded to each other by the first adhesive layer AL1. The first adhesive layer AL1 may cover a portion of the printed layer PIT.

The second adhesive layer AL2 may be disposed between the window WIN and the impact absorbing layer ISL. The window WIN and the impact absorbing layer ISL may be bonded to each other by the second adhesive layer AL2.

The third adhesive layer AL3 may be disposed between the impact absorbing layer ISL and the electronic panel EP. The impact absorbing layer ISL and the electronic panel EP may be bonded to each other by the third adhesive layer AL3.

The fourth adhesive layer AL4 may be disposed between the electronic panel EP and the panel protection layer PPL. The electronic panel EP and the panel protection layer PPL may be bonded to each other by the fourth adhesive layer AL4.

The fifth adhesive layer AL5 may be disposed between the panel protection layer PPL and the barrier layer BRL. The panel protection layer PPL and the barrier layer BRL may be bonded to each other by the fifth adhesive layer AL5.

The sixth adhesive layer AL6 may be disposed between the barrier layer BRL and the support plate PLT which will be described below. Specifically, the support plate PLT may be disposed under the barrier layer BRL, and the sixth adhesive layer AL6 may be disposed between the barrier layer BRL and the support plate PLT. The barrier layer BRL and the support plate PLT may be bonded to each other by the sixth adhesive layer AL6.

The sixth adhesive layer AL6 may overlap the first and second non-folding regions NFA1a and NFA2a and may not overlap the folding region FAa. That is, the sixth adhesive layer AL6 may not be disposed in the folding region FAa. The sixth adhesive layer AL6 may define an adhesive opening portion (e.g., a gap) therein, at the folding region FAa. The sixth adhesive layer AL6 may be disconnected at the folding region FAa.

The first to sixth adhesive layers AL1 to AL6 may include a transparent adhesive such as a pressure sensitive adhesive (PSA) or an optically clear adhesive (OCA). However, the type of adhesive is not limited thereto.

The thickness of the panel protection layer PPL may be less than the thickness of the window protection layer WP, and the thickness of the barrier layer BRL may be less than the thickness of the panel protection layer PPL. The thickness of the electronic panel EP may be less than the thickness of the barrier layer BRL and may be equal to the thickness of the window WIN. The thickness of the impact absorbing layer ISL may be less than the thickness of the electronic panel EP.

The thickness of the first adhesive layer AL1 may be equal to the thickness of the barrier layer BRL, and the thicknesses of the second adhesive layer AL2 and the third adhesive layer AL3 may be equal to the thickness of the panel protection layer PPL. The thickness of the fourth adhesive layer AL4 may be equal to the thickness of the fifth adhesive layer AL5.

The thicknesses of the fourth adhesive layer AL4 and the fifth adhesive layer AL5 may be less than the thickness of the electronic panel EP and may be greater than the thickness of the impact absorbing layer ISL. The thickness of the sixth adhesive layer AL6 may be less than the thickness of the impact absorbing layer ISL. The thickness of the hard coating layer HC may be less than the thickness of the sixth adhesive layer AL6.

Along a planar direction, the electronic panel EP, the impact absorbing layer ISL, the panel protection layer PPL, and the third and fourth adhesive layers AL3 and AL4 may have the same width. The window protection layer WP and the first adhesive layer AL1 may have the same width. As having a same width, corresponding side surfaces of layers may be at a substantially same position along the planar direction. In an embodiment, at a same side of the display device DD, the corresponding side surfaces may be coplanar with each other such as to be considered having a same width, without being limited thereto.

The widths of the electronic panel EP, the impact absorbing layer ISL, the panel protection layer PPL, and the third and fourth adhesive layers AL3 and AL4 may be greater than the widths of the window protection layer WP and the first adhesive layer AL1. The peripheries of the electronic panel EP, the impact absorbing layer ISL, the panel protection layer PPL, and the third and fourth adhesive layers AL3 and AL4 may be disposed outward of the peripheries of the window protection layer WP and the first adhesive layer AL1. That is, the electronic panel EP, the impact absorbing layer ISL, the panel protection layer PPL, and the third and fourth adhesive layers AL3 and AL4 may extend further than side surfaces of the window protection layer WP and the first adhesive layer AL1.

The width of the window WIN along the first direction DR1 may be greater than the widths of the electronic panel EP, the impact absorbing layer ISL, the panel protection layer PPL, and the third and fourth adhesive layers AL3 and AL4 in the first direction DR1. At the right side of FIG. 9A, for example, the periphery of the window WIN may be disposed outward of the peripheries of the electronic panel EP, the impact absorbing layer ISL, the panel protection layer PPL, and the third and fourth adhesive layers AL3 and AL4.

The width of the second adhesive layer AL2 in the first direction DR1 may be less than the widths of the window protection layer WP and the first adhesive layer AL1 in the first direction DR1. The periphery of the second adhesive layer AL2 may be disposed inward of the peripheries of the window protection layer WP and the first adhesive layer AL1. That is, one or more of the side surfaces of the second adhesive layer AL2 may be recessed from corresponding side surfaces of the window protection layer WP and the first adhesive layer AL1.

The widths of the barrier layer BRL and the fifth and sixth adhesive layers AL5 and AL6 may be less than the width of the second adhesive layer AL2. The peripheries of the barrier layer BRL and the fifth and sixth adhesive layers AL5 and AL6 may be disposed inward of the periphery of the second adhesive layer AL2.

The support plate PLT may be disposed under the display unit DSP and may support the display unit DSP. The support plate PLT may be disposed under the electronic panel EP and may support the electronic panel EP. The support plate PLT may have a higher rigidity than the display unit DSP.

The support plate PLT may include a non-metallic material. For example, the support plate PLT may include a fiber reinforced composite. The fiber reinforced composite may be carbon fiber reinforced plastic (CFRP) or glass fiber reinforced plastic (GFRP).

The support plate PLT including the fiber reinforced composite may be made relatively lightweight. The support plate PLT including the fiber reinforced composite may be lighter than a metal support plate formed of a metallic material and may have a modulus (e.g., elastic modulus) and rigidity similar to those of the metal support plate.

In addition, the support plate PLT including the fiber reinforced composite may be more easily shaped than the metal support plate. For example, the support plate PLT including the fiber reinforced composite may be more easily shaped through a laser process or a micro-blast process.

However, this is illustrative, and without being limited thereto, the support plate PLT may include a metallic material.

The support plate PLT may include a first non-folding portion PLT1, a folding portion PLF, and a second non-folding portion PLT2. The first non-folding portion PLT1 may overlap the first non-folding region NFA1a. The folding portion PLF may overlap the folding region FAa. The second non-folding portion PLT2 may overlap the second non-folding region NFA2a.

The support plate PLT may have a plurality of openings OP defined therein, at the folding portion PLF. The openings OP (e.g., plate openings) may be formed through thickness portions of the support plate PLT in the third direction DR3. The openings OP, when viewed in the second direction DR2, may be arranged in the first direction DR1 so as to be spaced apart from each other with the plate openings therebetween. The openings OP may be formed (or provided) through the laser process or the micro-blast process described above. Based on the first direction DR1, the width of the the openings OP may be less than the width of an adhesive opening portion of the sixth adhesive layer AL6.

Since the openings OP are defined in the portion of the support plate PLT which overlaps the folding region FAa, the flexibility of the support plate PLT which overlaps the folding region FAa (e.g., the folding portion PLF) may be increased. Thus, the support plate PLT may be folded about the folding region FAa.

The folding portion PLF may include branch portions BR. Each of the branch portions BR may be disposed between the openings OP adjacent to each other in the first direction DR1. The branch portions BR may be material portions (or solid portions) of the support plate PLT, and gaps corresponding to the openings OP may be defined by the branch portions BR. In an embodiment, the openings OP may be defined along an entire thickness portion of the support plate PLT at the folding region FAa, such as to be open at both an upper surface of the support plate PLT which is closest to the electronic panel EP and at a lower surface of the support plate PLT which is furthest from the electronic panel EP.

Although not illustrated, the display device DD may further include a digitizer, a shielding layer, and a heat radiating layer which are disposed under the support plate PLT.

Referring to FIG. 9B, the panel protection layer PPL and the fourth adhesive layer AL4 may not be disposed under the bending portion BA. The panel protection layer PPL and the fourth adhesive layer AL4 may be disposed under the second panel portion AA2 of the electronic panel EP. The data driver DDV may be disposed under the second panel portion AA2 of the electronic panel EP.

A printed circuit board PCB may be connected to the electronic panel EP at the second panel portion AA2. The printed circuit board PCB may be connected to one side of the second panel portion AA2, where the side is furthest from the first panel portion AA1. As the display module DM is bent at the bending portion BA, the second panel portion AA2 may be disposed under the first panel portion AA1. Accordingly, the data driver DDV and the printed circuit board PCB may be disposed under the first panel portion AA1, to face the first panel portion AA1 along the thickness direction of the display module DM which is folded.

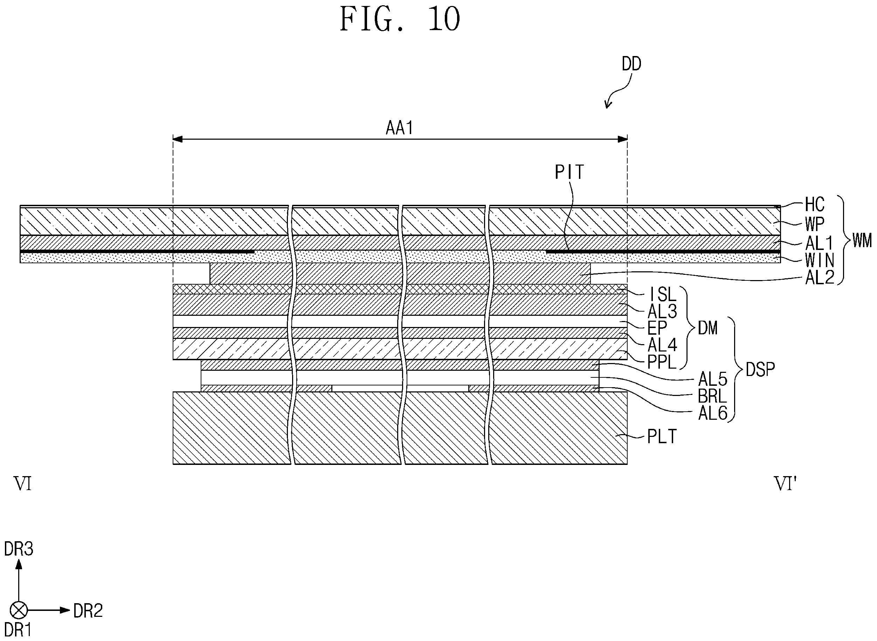

FIG. 10 is a cross-sectional view taken along line VI-VI' illustrated in FIG. 7.

FIG. 10 is a view illustrating a portion of the display unit DSP, a portion of the support plate PLT, and a portion of the window module WM.

FIG. 10 is a cross-sectional view of the display device DD as viewed in the first direction DR1.

The window module WM, the display unit DSP, and the support plate PLT illustrated in FIG. 10 are substantially the same as the window module WM, the display unit DSP, and the support plate PLT illustrated in FIG. 9A, except for the width in the second direction DR2. Therefore, the following description will be focused on a difference between the display device DD of FIG. 10 and the display device DD illustrated in FIG. 9A.

Referring to FIG. 10, the electronic panel EP, the impact absorbing layer ISL, the panel protection layer PPL, the third and fourth adhesive layers AL3 and AL4, and the support plate PLT may have the same width as each other.

The window WIN, the window protection layer WP, the first adhesive layer AL1, and the hard coating layer HC may have the same width.

The barrier layer BRL and the fifth and sixth adhesive layers AL5 and AL6 may have the same width.

The width of the window module WM in the second direction DR2 may be greater than the width of the display module DM in the second direction DR2. The peripheries of the window WIN, the window protection layer WP, the first adhesive layer AL1, and the hard coating layer HC may be disposed outward of the peripheries of the electronic panel EP, the impact absorbing layer ISL, the panel protection layer PPL, the third and fourth adhesive layers AL3 and AL4, and the support plate PLT in the second direction DR2.

The display module DM and the support plate PLT may have substantially the same width in the second direction DR2. The width of the second adhesive layer AL2 may be less than the widths of the display module DM and the support plate PLT. The periphery of the second adhesive layer AL2 may be disposed inward of the peripheries of the electronic panel EP, the impact absorbing layer ISL, the panel protection layer PPL, the third and fourth adhesive layers AL3 and AL4, and the support plate PLT.

The widths of the barrier layer BRL and the fifth and sixth adhesive layers AL5 and AL6 may be less than the widths of the display module DM and the support plate PLT. The peripheries of the barrier layer BRL and the fifth and sixth adhesive layers AL5 and AL6 may be disposed inward of the peripheries of the display module DM and the support plate PLT.

The width of the second adhesive layer AL2 may be less than the widths of the barrier layer BRL and the fifth and sixth adhesive layers AL5 and AL6. The periphery of the second adhesive layer AL2 may be disposed inward of the peripheries of the barrier layer BRL and the fifth and sixth adhesive layers AL5 and AL6.

FIG. 11 is a sectional view taken along line I-I' illustrated in FIG. 1A.

FIG. 11 illustrates a structure at a first edge portion of the electronic device EDa (refer to FIG. 1A) viewed in the second direction DR2.

FIG. 11 is a view illustrating the electronic device EDa in an unfolded state which has the display device DD bent within the electronic device EDa.

The window module WM, the display unit DSP, and the support plate PLT of FIG. 11 are identical to the window module WM, the display unit DSP, and the support plate PLT illustrated in FIGS. 9A and 9B and therefore will be omitted from the description or will be briefly described.

Referring to FIGS. 3 and 11, a first molding part MP1 as a first molded member may be disposed on one side of the display device DD along the first direction DR1. The first molding part MP1 may be disposed on one side of the support plate PLT and one side of the display unit DSP which correspond to each other (e.g., at a same side of the electronic device EDa). The first molding part MP1 may be disposed under the window WIN. The one side of the display unit DSP may be a side parallel to the folding axis FXa (refer to FIG. 1A) and adjacent to the bending portion BA among the four sides of the display device DD which are arranged in a plan view.

As used herein, a "one side" may be considered an outer side surface or an end surface of a respective layer. Referring to FIG. 11, the first molding part MP1 may cover the one side of the support plate PLT, the one side of the display unit DSP, and the bending portion BA of the display module DM which is bent at the bending portion BA. The first molding part MP1 may fix the positions of the support plate PLT, the display unit DSP, and the bending portion BA within the unfolded (or flat) form of the electronic device EDa.

Accordingly, when the electronic device EDa is folded relative to the unfolded form, the first molding part MP1 may prevent movement or slipping of edges (e.g., outer edges or side surfaces) of the display module DM, the panel protection layer PPL, the fifth adhesive layer AL5, the barrier layer BRL, the sixth adhesive layer AL6, and the support plate PLT at the first edge portion.

The bracket EDC may include a first bracket BR1 and a second bracket BR2. The first bracket BR1 may be disposed under the display device DD. The first and second brackets BR1 and BR2 may be representative of the first cases EDC1 illustrated in FIG. 3. The display device DD and the first molding part MP1 may be disposed on an upper surface BR1-U1 of the first bracket BR1.

The second bracket BR2 may be disposed on the first bracket BR1. The second bracket BR2 may extend from a virtual plane corresponding to the upper surface BR1-U1 of the first bracket BR1, and in the third direction DR3. The second bracket BR2 may extend in a planar direction from the first edge portion and toward the window WIN. A portion of the second bracket BR2 may have a curved cross-sectional shape.

A first corner EG1 of the second bracket BR2 which is closest to a side surface of the window module WM may be located in a higher position than the upper surface of the hard coating layer HC, along the third direction DR3. The first corner EG1 may be defined as a point of the second bracket BR2 having the maximum height from the upper surface BR1-U1 of the first bracket BR1 in the third direction DR3. The outer surface of the second bracket BR2 may be defined as a surface facing away from the display device DD. The outer surface of the second bracket BR2 may define an outer surface of the electronic device EDa at the first edge portion thereof.

A first receiving groove GR1 may be defined by portions of the upper surface BR1-U1 of the first bracket BR1 and the inner surface of the second bracket BR2 which. The inner surface of the second bracket BR2 may be defined as a surface which faces the display device DD and is opposite to the outer surface.

A portion of the window WIN may be disposed in the first receiving groove GR1. The outer periphery of the window WIN may be disposed in the first receiving groove GR1. A portion of the window WIN which overlaps the second bracket BR2 may be defined as a first portion PT1.

An end portion of the window WIN may be bent in a curved shape. The bent end portion of the window WIN may be disposed in a curved shape in the first receiving groove GR1. The first portion PT1 may be disposed in a curved shape in the first receiving groove GR1.

The first adhesive layer AL1, the window protection layer WP, and the hard coating layer HC of the window module WM may not be disposed in the first receiving groove GR1. The first adhesive layer AL1, the window protection layer WP, and the hard coating layer HC may not overlap the second bracket BR2. As not being disposed in or not overlapping, elements may be spaced apart from each other or adjacent to each other along a planar direction.

The bracket EDC may include a protrusion BPP. The protrusion BPP may be disposed protruded from the virtual plane of the upper surface BR1-U1 of the first bracket BR1. The protrusion BPP may extend from the upper surface BR1-U1 of the first bracket BR1 in the third direction DR3. Substantially, the protrusion BPP may be integrally formed with the first bracket BR1. That is, the protrusion BPP and/or the second bracket BR2 may be a single, unitary body with the first bracket BR1.

For example, the protrusion BPP, when viewed in the second direction DR2, may have a triangular cross-sectional shape. However, without being limited thereto, the protrusion BPP may have various shapes. Opposite side surfaces of the protrusion BPP which face away from each other in the first direction DR1 may be inclined. The extension directions of the inclined surfaces may be opposite to each other.

A first adhesive part GRP1 may be disposed between a first side surface of the protrusion BPP and the first portion PT1 of the window WIN. One portion of the first adhesive part GRP1 may be attached to the first portion PT1 at the lower surface thereof. Another portion of the first adhesive part GRP1 may be attached to one of the opposite side surfaces of the protrusion BPP which face away from each other in the first direction DR1. The one side surface of the protrusion BPP may be defined as a side surface facing away from the other side surface which faces the first molding part MP1. The first portion PT1 and the protrusion BPP may be bonded to each other by the first adhesive part GRP1 as a first adhesive member. The curved state of the first portion PT1 may be maintained by the first adhesive part GRP1.

FIG. 12 is a cross-sectional view taken along line II-II' illustrated in FIG. 1A.

FIG. 12 illustrates a structure at a second edge portion of the electronic device EDa viewed in the second direction DR2.

FIG. 12 is a view illustrating the electronic device EDa in an unfolded state which has the display device DD curved within the electronic device EDa (e.g., at the first edge portion shown in FIG. 11, for example).

The window module WM, the display unit DSP, and the support plate PLT of FIG. 12 are identical to the window module WM, the display unit DSP, and the support plate PLT illustrated in FIGS. 9A and 9B and therefore will be omitted from the description or will be briefly described.

Referring to FIGS. 3 and 12, a second molding part MP2 as a second molded member may be disposed on an opposite side of the display device DD along the first direction DR1. The opposite side of the display device DD may be defined as a side facing away from the one side adjacent to the bending portion BA among the two opposing sides of the display device DD which are parallel to the folding axis FXa (refer to FIG. 1A). The second molding part MP2 may be disposed on an opposite side of the fifth adhesive layer AL5, an opposite side of the barrier layer BRL, an opposite side of the sixth adhesive layer AL6, and an opposite side of the support plate PLT which correspond to each other (e.g., at a same side of the electronic device EDa). The second molding part MP2 may cover the opposite side of the fifth adhesive layer AL5, the opposite side of the barrier layer BRL, the opposite side of the sixth adhesive layer AL6, and the opposite side of the support plate PLT. The opposite side of the fifth adhesive layer AL5, the opposite side of the barrier layer BRL, the opposite side of the sixth adhesive layer AL6, and the opposite side of the support plate PLT may be defined as sides facing a third bracket BR3 which will be described below. The second molding part MP2 may protect the support plate PLT, the barrier layer BRL, and the fifth and sixth adhesive layers AL5 and AL6 from moisture or foreign matter.

The first bracket BR1 as a first bracket portion may be disposed under the electronic panel EP. A first upper surface BR1-U of the first bracket BR1 may include an upper surface 1-1 BR1-U1 as a first upper surface portion and an upper surface 1-2 BR1-U2 as a second upper surface portion. The upper surface at the protrusion BPP may be considered a portion of the first upper surface portion, without being limited thereto. The upper surface 1-1 BR1-U1 and the upper surface 1-2 BR1-U2 may be disposed in different planes with a step therebetween. The upper surface 1-1 BR1-U1 may be located in a higher position than the upper surface 1-2 BR1-U2, relative to a reference such as the lower surface of the bracket EDC which is defined by the first bracket BR1. Since the upper surface 1-1 BR1-U1 and the upper surface 1-2 BR1-U2 are disposed with the step therebetween, a receiving groove 2-1 GR2-1 may be defined by the first bracket BR1 as a recess.

The bracket EDC may further include the third bracket BR3. The third bracket BR3 may be disposed extended from a virtual plane corresponding to the upper surface 1-2 BR1-U2. The third bracket BR3 may extend from the upper surface 1-2 BR1-U2 in the third direction DR3. A portion of the third bracket BR3 may have a curved shape when viewed in the second direction DR2. Although not illustrated, the third bracket BR3 and the second bracket BR2 may be disposed on opposite sides of the first bracket BR1 which face away from each other in the first direction DR1. That is, the second bracket BR2 and the third bracket BR3 may be spaced apart from each other in the first direction DR1.

A second corner EG2 of the third bracket BR3 may be located in a higher position than the upper surface of the hard coating layer HC. The third bracket BR3 may overlap the hard coating layer HC, while the second bracket BR2 is adjacent to an end of the hard coating layer HC to be non-overlapping therewith. The second corner EG2 may be defined as a point having the maximum height from the upper surface 1-1 BR1-U1 of the first bracket BR1 to the outer surface of the third bracket BR3 in the third direction DR3. The outer surface of the third bracket BR3 may be defined as a surface facing away from the surface of the third bracket BR3 which faces the display device DD.

A receiving groove 2-2 GR2-2 may be formed by the inner surface of the third bracket BR3. The inner surface of the third bracket BR3 may be defined as a surface which faces the display device DD. Substantially, the receiving groove 2-2 GR2-2 may be integrally defined with the receiving groove 2-1 GR2-1, such as to form a single receiving space. That is, a second receiving groove GR2 may be defined at inner surfaces of both the first bracket BR1 and the third bracket BR3, together with various layers in the receiving space.

The display device DD and the second molding part MP2 may be accommodated in the bracket EDC. The support plate PLT may be disposed on the upper surface 1-1 BR1-U1 of the first bracket BR1. The second molding part MP2 may be disposed on the upper surface 1-1 BR1-U1 of the first bracket BR1.

A portion of the window module WM and a portion of the display module DM may be disposed in the second receiving groove GR2 when the display device DD is disposed on the upper surface 1-1 BR1-U1 of the first bracket BR1. The portion of the window module WM and the portion of the display module DM may be disposed in the receiving groove 2-2 GR2-2. The peripheries of the window module WM and the display module DM which extend further than side surfaces of various other may be disposed in the receiving groove 2-2 GR2-2. A portion of the window WIN which overlaps the third bracket BR3 may be defined as a second portion PT2.

The portion of the window module WM and the portion of the display module DM which are extended into the second receiving groove GR2 may be bent in a curved shape. The portion of the window module WM and the portion of the display module DM may be disposed in a curved shape in the receiving groove 2-2 GR2-2. The second portion PT2 may be disposed in a curved shape in the receiving groove 2-2 GR2-2.

The electronic device EDa may further include a guide part GPa as a guide for the display device DD. The guide part GPa may be disposed between the first bracket BR1 and a lower surface of the display module, such as the panel protection layer PPL. One portion of the guide part GPa may be disposed on the upper surface BR1-U of the first bracket BR1. For example, another portion of the guide part GPa may be disposed on the lower surface of the panel protection layer PPL.

The guide part GPa may include a track CT and a wheel WH which is disposed inside the track CT bent in a curved shape. One portion of the track CT may be disposed on and extended along the upper surface BR1-U of the first bracket BR1, and another portion of the track CT may be disposed on and extended along the lower surface of the display module DM.

The track CT may include a first track portion CT1, a bent track portion CBT, and a second track portion CT2. The first track portion CT1 may be defined as a portion of the track CT extended along the upper surface BR1-U of the first bracket BR1. The second track portion CT2 may be defined as a portion of the track CT which faces the first track portion CT1 and is extended along the lower surface of the display module DM. The bent track portion CBT may be defined as a portion of the track CT which is bent and which connects the first track portion CT1 and the second track portion CT2 to each other.

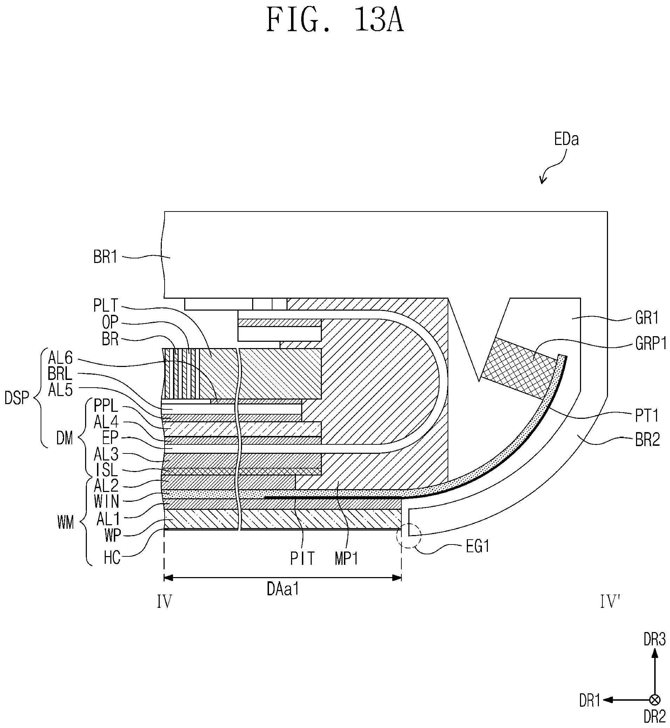

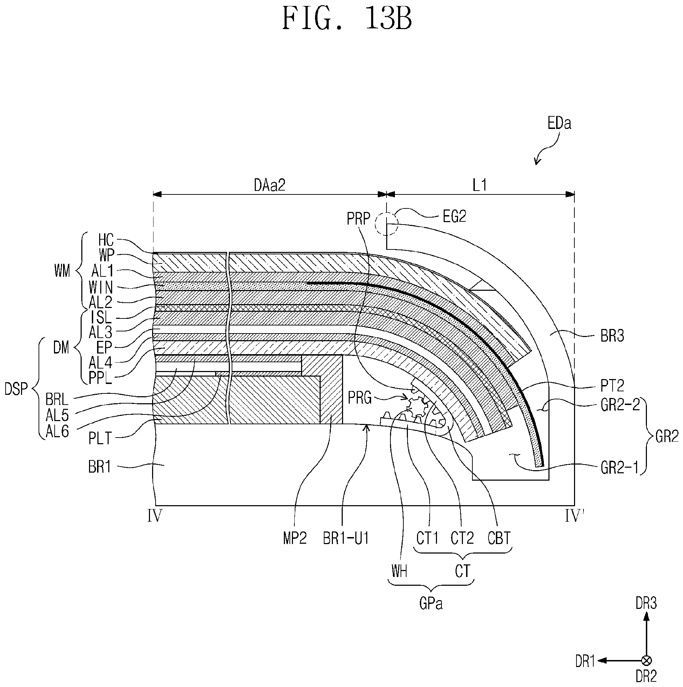

When viewed in the second direction DR2, the first track portion CT1 may be shorter than the second track portion CT2 in a direction along a respective member (e.g., the display module DM and the first bracket BR1. However, without being limited thereto, the first track portion CT1 may have the same length as the second track portion CT2, or may be longer than the second track portion CT2. Detailed description thereabout will be given below with reference to FIGS. 13A and 13B.

Each of the first track portion CT1, the second track portion CT2, and the bent track portion CBT may include track protrusions PRP. The track protrusions PRP may be disposed on or protruded from virtual surfaces of the first track portion CT1 and the second track portion CT2 which face each other. The track protrusions PRP may be disposed on a surface of the bent track portion CBT which faces the wheel WH.

The wheel WH may be disposed between the first track portion CT1 and the second track portion CT2. The wheel WH and the bent track portion CBT may be arranged in the first direction DR1, with the bent track portion CBT being closer to the second end portion of the electronic device EDa than the wheel WH. The wheel WH may be variously engaged with the first track portion CT1, the second track portion CT2, and the bent track portion CBT.

Wheel protrusions PRG may be disposed along the outer surface of the wheel WH. The wheel protrusions PRG may be spaced apart from each other at predetermined intervals along the outer surface of the wheel WH. The track protrusions PRP of the first track portion CT1, the second track portion CT2, and the bent track portion CBT may be variously engaged with the wheel protrusions PRG. Accordingly, the wheel WH may be rotated about a rotational axis parallel to the second direction DR2 when the track protrusions PRP move along the outer surface of the wheel WH. Detailed description thereabout will be given below with reference to FIGS. 13A and 13B.

In an embodiment, the wheel WH may be actively driven to rotate and a frictional force between the wheel WH which rotates and the display module DM may passively slide the display device DD along the sliding direction. In an embodiment, active sliding of the display module DM may passively rotate the wheel WH and allow the display device DD to slide in the sliding direction.

The electronic device EDa may further include a tip portion TP. The tip portion TP may be disposed on the inner surface of the third bracket BR3. The tip portion TP may extend from the inner surface of the third bracket BR3 and in a direction toward the hard coating layer HC. The tip portion TP may be disposed adjacent to an upper portion of the third bracket BR3. The inner surface of the third bracket BR3 may be defined as a surface which faces the display device DD.

For example, the tip portion TP may include an elastic material. In this case, as illustrated in FIG. 12, a distal end of the tip portion TP may make contact with the hard coating layer HC. As being in contact, elements may form an interface therebetween. The tip portion TP may be disposed between the third bracket BR3 and the hard coating layer HC and may block foreign substances introduced into the second receiving groove GR2 from the outside of the electronic device EDa.

However, without being limited thereto, the tip portion TP may be spaced apart from the hard coating layer HC by a predetermined distance. The distance between the tip portion TP and the hard coating layer HC may be adjusted depending on the size of foreign matter. The distance may be defined at positions along the portion of the upper surface of the hard coating layer HC which faces the inner surface of the third bracket BR3, such as in a direction normal to the upper surface.

Although it has been described that the tip portion TP includes an elastic material, the present disclosure is not limited thereto, and the tip portion TP may be an inelastic body. The tip portion TP may include metal or plastic. In this case, the tip portion TP may be spaced apart from the hard coating layer HC by a predetermined distance.

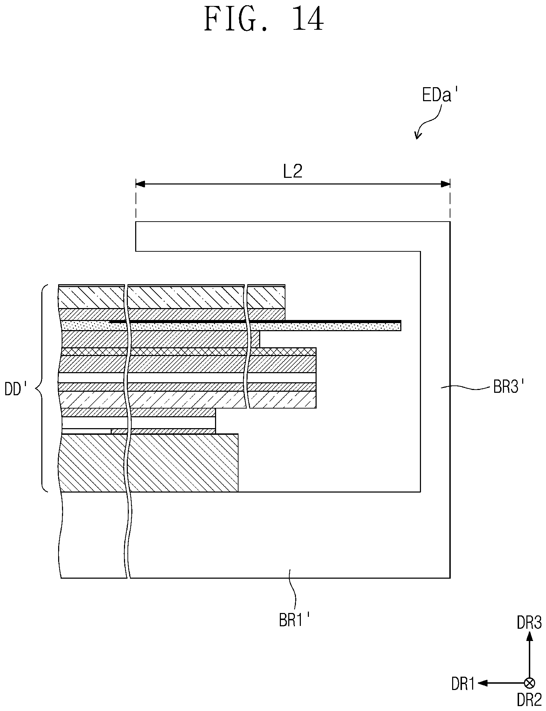

FIGS. 13A and 13B are cross-sectional views taken along line IV-IV' illustrated in FIG. 1B. FIG. 13A is a view of the structure in FIG. 11 which inverted and facing the structure in FIG. 12, to each be disposed at the second edge portion of the electronic device EDa which is folded in FIG. 1B. FIG. 14 is a cross-sectional view of an electronic device according to a comparative example.

FIGS. 13A and 13B are viewed of respective edge portions of the electronic device EDa in a folded state which has the display device DD bent within the electronic device EDa. While the views in FIGS. 13A and 13B are shown separated for illustration, it will be understood that the structures of FIGS. 13A and 13B may be directly adjacent to each other at the second edge portion of the electronic device EDa folded in FIG. 1B.

FIG. 14 is a view illustrating a second edge portion of an electronic device EDa' which corresponds to the third bracket BR3 of FIG. 13B.

FIG. 14 is a cross-sectional view corresponding to an opposite side of electronic device EDa' (e.g., at the second edge portion) according to the comparative example.

Description of the electronic device EDa' illustrated in FIG. 14 will be focused on a difference from the electronic device EDa illustrated in FIG. 13B.

The display device DD, the first bracket BR1, the second bracket BR2, the third bracket BR3, the guide part GPa, the first molding part MP1, the second molding part MP2, and the first adhesive part GRP1 of FIGS. 13A and 13B are identical to the display device DD, the first bracket BR1, the second bracket BR2, the third bracket BR3, the guide part GPa, the first molding part MP1, the second molding part MP2, and the first adhesive part GRP1 of FIGS. 11 and 12 and therefore will be omitted from the description or will be briefly described.

Referring to FIGS. 1A, 1B, and 13B, the third region FAa of the electronic device EDa may be folded about the folding axis FXa extending in the second direction DR2. When the electronic device EDa is folded at the third region FAa, the electronic device EDa may be in-folded such that the first region NFA1a and the second region NFA2a face each other.

When the electronic device EDa is folded, the first corner EG1 and the second corner EG2 may face each other at the second edge portion of the electronic device EDa. In the electronic device EDa which is unfolded like FIG. 1A, the height of the first corner EG1 and the height of the second corner EG2 may be greater than the height of the upper surface of the hard coating layer HC. Accordingly, when the electronic device EDa is folded like in FIG. 1B, the first and second corners EG1 and EG2 may make contact with each other before portions of the upper surface of the hard coating layer HC overlapping the first display region Daa1 and the hard coating layer HC overlapping the second display region Daa2 make contact with each other. As illustrated by the views of FIGS. 13A and 13B representing a stacked structure at the second edge portion of the electronic device EDa which is folded, the edge portions of the bracket EDC are closer to each other along the third direction than the closest respective portions of the hard coating layer HC. Accordingly, damage to the hard coating layer HC may be prevented when the electronic device EDa is folded.

The one side of the display device DD adjacent to the second bracket BR2 (e.g., at the first edge portion) may be fixed by the first molding part MP1. Accordingly, when the electronic device EDa is folded, the peripheries of the window module WM, the display module DM, the panel protection layer PPL, the fifth adhesive layer AL5, the barrier layer BRL, the sixth adhesive layer AL6, and the support plate PLT may be fixed in position without moving or slipping.

When the electronic device EDa is folded, a slip may occur on the opposite side of the display device DD adjacent to the third bracket BR3 (e.g., at the second edge portion). The peripheries of the window module WM, the display module DM, the panel protection layer PPL, the fifth adhesive layer AL5, the barrier layer BRL, the sixth adhesive layer AL6, and the support plate PLT may move or slip. That is, the second end portions (e.g., peripheries) of the window module WM, the display module DM, the panel protection layer PPL, the fifth adhesive layer AL5, the barrier layer BRL, the sixth adhesive layer AL6, and the support plate PLT are movable or slippable with respect to the bracket EDC.

When the second end portion peripheries of the window module WM, the display module DM, the fifth adhesive layer AL5, the barrier layer BRL, the sixth adhesive layer AL6, and the support plate PLT slip or move along the inner surface of the bracket EDC, the second end portion of the display module DM and the window module WM may be moved along the second receiving groove GR2, the second end portion of the second portion PT2 of the window WIN may be moved into the receiving groove 2-1 GR2-1, and the area of the second portion PT2 overlapping the third bracket BR3 may be increased. The display module DM and the window module WM may be in a curved state within the second receiving groove GR2 of the bracket EDC. Accordingly, the slipped peripheries of the window module WM and the display module DM may not be visible to the user.

Referring to FIG. 14, when the electronic device EDa' according to the comparative example is folded, the second end portion periphery of a display device DD' may slip along the third bracket BR3'. The display device DD' may be disposed in a space defined by a first bracket BR1' and a third bracket BR3'. At this time, the periphery of the display device DD' may not be curved.

As illustrated in FIG. 14, to prevent a slip from being visible from the outside, the third bracket BR3' may have an inverted and reversed L-shape. In this case, a portion of the third bracket BR3' which extends in the first direction DR1 may have a second length L2.

Referring to FIG. 13B, when the electronic device EDa is folded, the peripheries of the window module WM, the display module DM, and the panel protection layer PPL may be disposed in the second receiving groove GR2 in a state of being bent in a curved shape to provide the display device DD which is bent.

According to one or more embodiment, the third bracket BR3 may overlap the periphery of the display device DD to prevent a slip from being visible from the outside. The third bracket BR3 may have a first length L1 in the first direction DR1 when viewed in the second direction DR2, even in the electronic device EDa which is folded. The first length L1 may be less than the second length L2.

Referring to FIGS. 1A, 1B, 13B, and 14, the third bracket BR3 which covers a portion of the display device DD may be shorter in the first direction DR1 than the conventional bracket structure since the display device DD of FIGS. 13A and 13B are disposed in a curved state at the second receiving groove GR2. Accordingly, the planar area of the display device DD which overlaps the third bracket BR3 (e.g., defined in a DR1-DR2 plane) may be decreased. Thus, the planar area of the display surface Dsa of the electronic device EDa may be increased. For example, where the visible portion of the display surface DSa is defined between inner side surfaces of the bracket EDC at the first edge EG1 and the second edge EG2.

Referring to FIG. 13B, when the opposite side (e.g., the second end portion) of the display device DD moves in a sliding direction (e.g., along the first direction DR1), the track CT attached to the lower surface of the panel protection layer PPL may be moved. The track CT may move together with the panel protection layer PPL and various layers attached thereto (e.g., layers of the display device DD). In an embodiment, the track CT may be fixedly attached to the panel protection layer PPL at a location along the second track portion CT2. Referring to FIG. 12 and 13B, an unattached portion of the track CT may be extended from the fixed location in a direction towards the first track portion CT1. An unattached portion of the track CT at the second track portion CT2 in FIG. 12 may be moved from a lower surface of the panel protection layer PPL and onto the upper surface BR1-U1 of the first bracket BR1, while traveling along the outer surface of the wheel WH, to be included in the track bent portion CBT and/or the first track portion CT1 in FIG. 13B. The first track portion CT1 may be disposed along the upper surface BR1-U1 of the first bracket BR1.

The track protrusions PRP of the track CT at the second track portion CT2 may be moved while being engaged with the wheel protrusions PRG disposed on the surface of the wheel WH. As the second track portion CT2 moves in a clockwise direction around the wheel WH when the electronic device EDa is folded, the length of the first track portion CT1 extended along the upper surface BR1-U1 of the first bracket BR1 may be increased, and the length of the second track portion CT2 extended along the lower surface of the panel protection layer PPL may be decreased. In the electronic device EDa which is folded, the length of the first track portion CT1 may be greater than the length of the second track portion CT2.

The direction of movement of the display module DM and the window module WM may be adjusted by the guide part GPa connected to the display module DM and the window module WM. That is, since the guide part GPa is disposed between the first bracket BR1 and the display module DM, the display module DM and the window module WM may be moved along the second receiving groove GR2 defined by the first and third brackets BR1 and BR3. Accordingly, the window module WM and the display module DM may not be separated out of the bracket EDC (refer to FIG. 3). Thus, the folding reliability of the electronic device EDa may be improved.

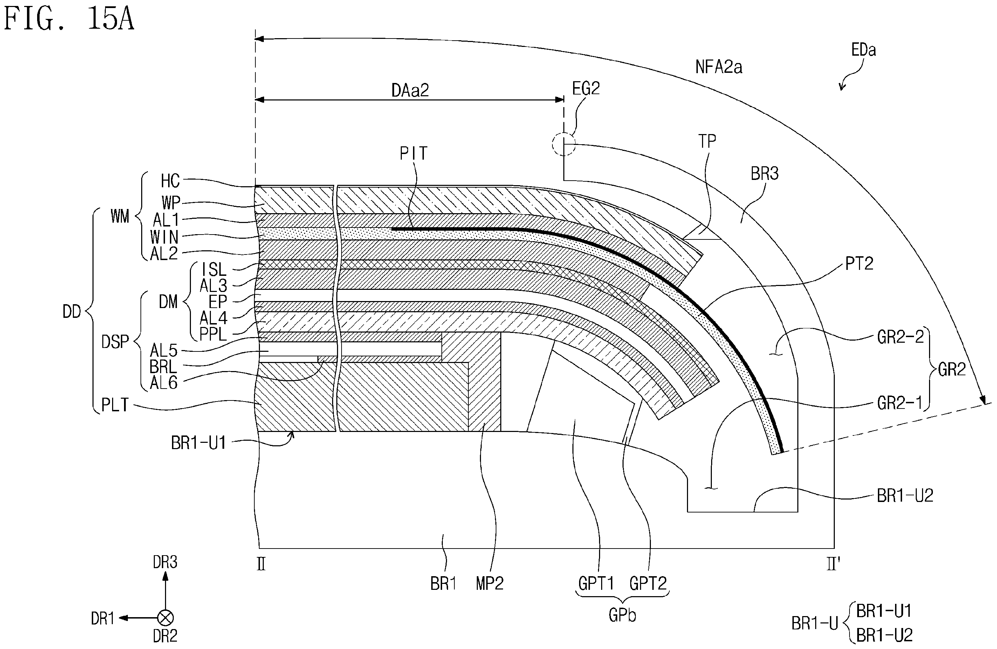

FIGS. 15A to 15E are views for explaining a guide part according to an embodiment of the present disclosure.

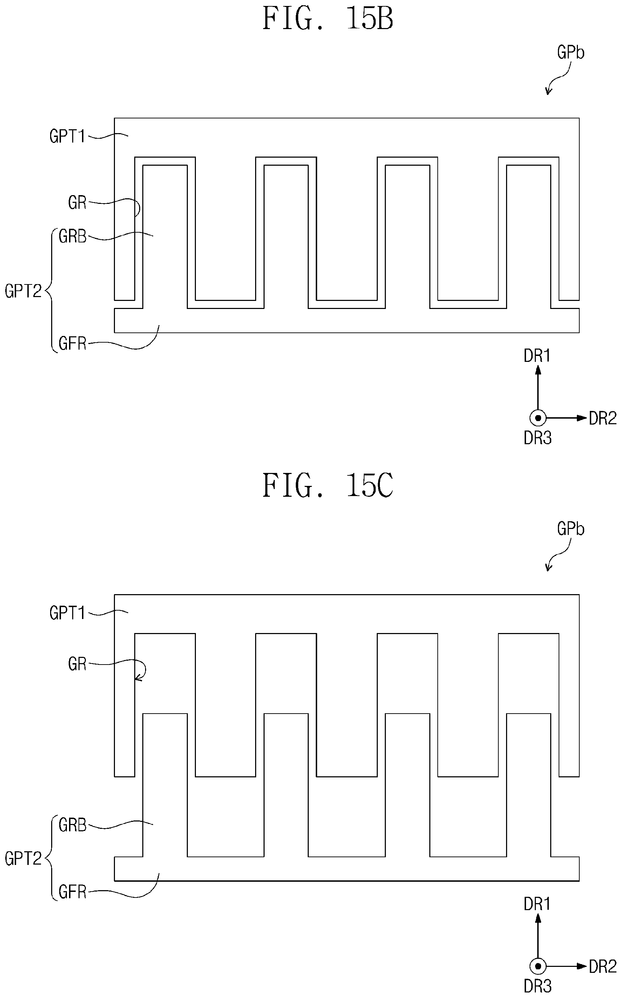

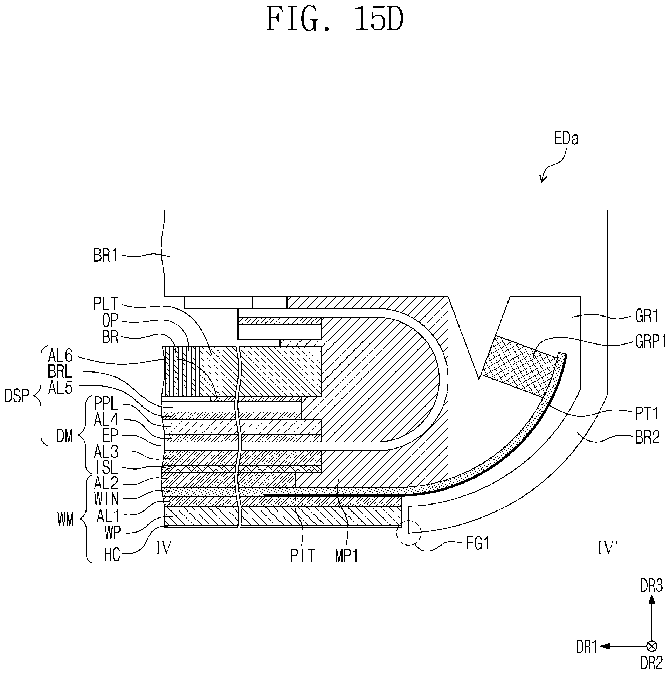

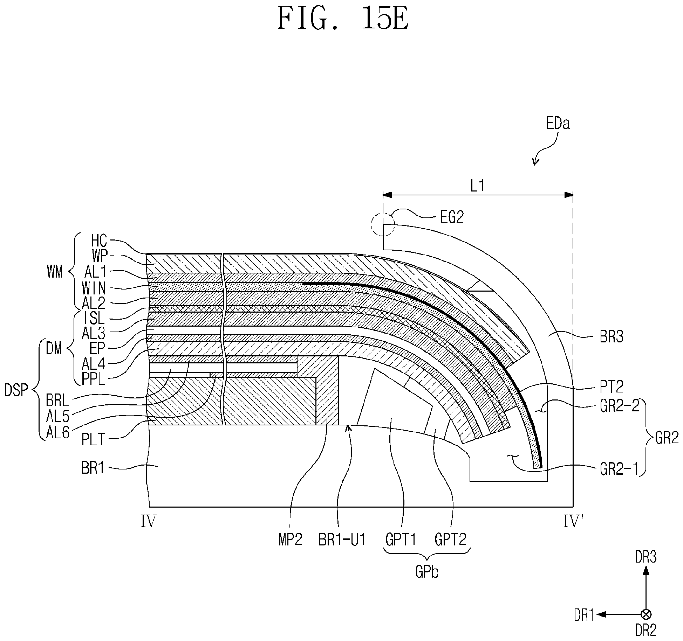

FIG. 15A is a cross-sectional view taken along line II-II' illustrated in FIG. 1A, FIGS. 15B and 15C are top plan views of a second guide part GPb illustrated in FIG. 15A, and FIGS. 15D and 15E are cross-sectional views taken along line IV-IV' illustrated in FIG. 1B.

FIG. 15A illustrates the electronic device EDa in an unfolded state, and FIGS. 15D and 15E illustrates the electronic device EDa in a folded state. Within the electronic device EDa which is unfolded (FIG. 15A) and folded (FIGS. 15D and 15E), the display device DD is bent at the first end portion (line I-I' in FIG. 1A) and at the second end portion (line II-II' in FIG. 1A and line IV-IV' in FIG. 1B). FIG. 15E is a view of the structure in FIG. 11 which inverted and facing the structure in FIG. 15A, to each be disposed at the second edge portion of the electronic device EDa which is folded in FIG. 1B.

The display device DD, the first bracket BR1, the second bracket BR2, the third bracket BR3, the second molding part MP2, the first adhesive part GRP1, and the tip portion TP illustrated in FIGS. 15A, 15D and 15E are identical to the display device DD, the first bracket BR1, the second bracket BR2, the third bracket BR3, the second molding part MP2, the first adhesive part GRP1, and the tip portion TP of FIGS. 13A and 13B and therefore will be omitted from the description or will be briefly described.

Referring to FIG. 15A, the second guide part GPb as a guide for the display device DD may be disposed between the first bracket BR1 and the display module DM. The second guide part GPb may be connected to the first bracket BR1. The second guide part GPb may be connected to the display module DM.

Referring to FIGS. 15A to 15C, the second guide part GPb may include a first guide plate GPT1 and a second guide plate GPT2. The first guide plate GPT1 may be connected to the first bracket BR1, and the second guide plate GPT2 may be connected to the display module DM. The first guide plate GPT1 may be fixedly connected to the first bracket BR1, and the second guide plate GPT2 may be fixedly connected to the display module DM and moveable together with the display module DM. The first guide plate GPT1 may be disposed on the upper surface BR1-U of the first bracket BR1. The second guide plate GPT2 may be disposed under the display module DM at a position thereof overlapping the second portion PT2. For example, the second guide plate GPT2 may be disposed on the lower surface of the panel protection layer PPL.

The first guide plate GPT1 may have the shape of a portion of a rectangle when viewed from above the plane (e.g., plan view of the DR1-DR2 plane). However, this is illustrative, and the first guide plate GPT1 may have various planar shapes.

The first guide plate GPT1 may have (or define) a plurality of guide grooves GR defined therein. The guide grooves GR may lengthwise extend in the first direction DR1 from one of opposite sides of the first guide plate GPT1 which face away from each other in the first direction toward the other. The one side of the first guide plate GPT1 may be defined as a side facing the second guide plate GPT2.

The guide grooves GR may be spaced apart from each other in the second direction DR2. Although four guide grooves GR are illustrated in FIGS. 15B and 15C, the number of guide grooves GR may be varied.

The second guide plate GPT2 may include a plurality of guide ribs GRB and a guide frame GFR. The guide frame GFR, when viewed from above the plane, may have a rectangular shape lengthwise extending in the second direction DR2.

The guide ribs GRB may be disposed on one of opposite sides of the guide frame GFR which face away from each other in the first direction DR1. The guide ribs GRB may extend from the one side of the guide frame GFR in the first direction DR1. Substantially, the guide ribs GRB may be integrally formed with the guide frame GFR. The one side of the guide frame GFR in the first direction DR1 may be defined as a side facing the first guide plate GPT1.

The guide ribs GRB, when viewed from above the plane, may be arranged in the second direction DR2 so as to be spaced apart from each other in the second direction DR2. Although four guide ribs GRB are illustrated in FIGS. 15B and 15C, the present disclosure is not limited thereto, and the number of guide ribs GRB may be varied to correspond to the number of guide grooves GR.

The guide ribs GRB, when viewed from above the plane, may have a planar shape corresponding to the planar shape of the first guide plate GPT1 at the guide grooves GR. For example, the guide ribs GRB may have a rectangular shape.

The guide ribs GRB may reciprocate toward the inside or outside of the guide grooves GR along the sliding direction (e.g., the first direction DR1). That is, the first guide plate GPT1 and the second guide plate GPT2 are movable relative to each other, along the sliding direction. A length portion of the guide ribs GRB may be variable by insertion of the guide rib GRB into or retraction of the guide rib GRB out of a respective groove among the guide grooves GR. A state in which substantially an entire length of the guide ribs GRB is disposed in the guide grooves GR may be defined as a first state. A state in which a length of the guide ribs GRB disposed in the guide grooves GR which is less than that of the first state, may be defined as a second state.

When the second guide part GPb is changed from the first state to the second state, the separation distance between the first guide plate GPT1 and the guide frame GFR, along the sliding direction, may be increased.

Referring to FIGS. 15A to 15E, when the electronic device EDa is unfolded (FIG. 15A and 15B), the second guide part GPb may be in the first state. Each of the guide ribs GRB may be disposed in a corresponding guide groove GR among the guide grooves GR. Here, a maximum length of the guide ribs GRB may be extended into the guide grooves GR.

When the electronic device EDa is folded (FIGS. 15C, 15D and 15E), the display module DM and the window module WM may be slid into the second receiving groove GR2. The area of the second portion PT2 overlapping the third bracket BR3 may be increased. Here, a maximum length of the display module DM and the window module WM may be disposed overlapping the third bracket BR3.

When the electronic device EDa is folded, the second guide part GPb may be in the second state. Specifically, the second guide plate GPT2 connected to the display module DM may move together with the display module DM. The second guide plate GPT2 may move relative to the first bracket BR1 and along the upper surface BR1-U of the first bracket BR1. The guide ribs GRB of the second guide plate GPT2 may move out of the guide grooves GR along the sliding direction. The distance between the guide frame GFR and the first guide plate GPT1 may be increased. Here, a maximum distance (or maximum displacement) may be defined between the guide frame GFR of the second guide plate GPT2 and a guide frame of the first guide plate GPT1, and a minimum length of the guide ribs GRB may be in the guide grooves GR.

Since the guide plates are slidable relative to each other, the direction of movement of the display module DM and the window module WM may be adjusted by the second guide part GPb which includes the first guide plate GPT1 connected to the first bracket BR1 and the second guide plate GPT2 connected to the display module DM. When the electronic device EDa is folded, the display module DM and the window module WM may be moved along the second receiving groove GR2 (e.g., along both the sliding direction and the thickness direction) by the second guide part GPb. Accordingly, the window module WM and the display module DM may not be separated out of the bracket EDC and may remain within the bracket EDC (refer to FIG. 3). Thus, the folding reliability of the electronic device EDa may be improved.

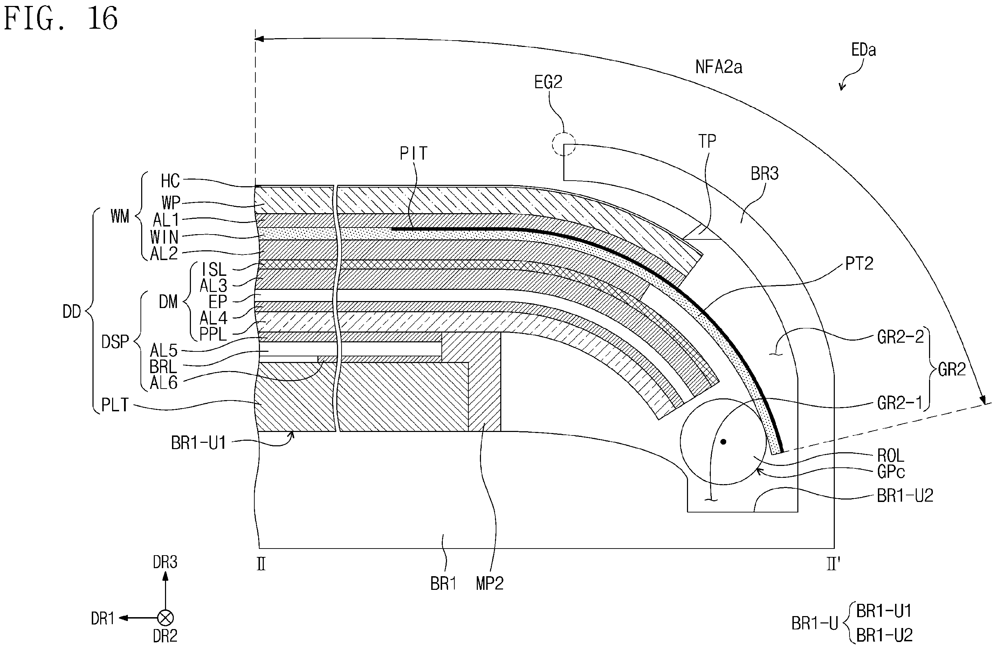

FIG. 16 is a view for explaining a guide for guiding the display module DM according to an embodiment of the present disclosure.

FIG. 16 is a cross-sectional view taken along line II-II' illustrated in FIG. 1A.

FIG. 16 is a view illustrating the electronic device EDa in an unfolded state. Here, the display device DD may be bent within the electronic device EDa, at the first end portion (line I-I' in FIG. 1A) and at the second end portion (line II-II' in FIG. 1A and line IV-IV' in FIG. 1B).

The display device DD, the first bracket BR1, the third bracket BR3, and the tip portion TP illustrated in FIG. 16 are identical to the display device DD, the first bracket BR1, the third bracket BR3, and the tip portion TP of FIG. 12 and therefore will be omitted from the description or will be briefly described.

Referring to FIG. 16, a third guide part GPc may include a roller ROL when viewed in the second direction DR2. The roller ROL may be disposed between the first bracket BR1 and the window WIN. The roller ROL may be in contact with the lower surface of the second portion PT2. The roller ROL may be rotated about a rotational axis parallel to the second direction DR2.

When the electronic device EDa is folded, the second portion PT2 of the window WIN may be moved along the sliding direction and along the third direction DR3. The second portion PT2 may be moved along the outer surface of the roller ROL. The roller ROL may be rotated in the clockwise direction about the rotational axis parallel to the second direction DR2 by the second portion PT2, in folding of the electronic device EDa.

The second portion PT2 of the window WIN may be moved along the second receiving groove GR2 together with the rotation of the roller ROL. Accordingly, the window module WM and the display module DM may not be separated out of the bracket EDC (refer to FIG. 3). In an embodiment, the roller ROL may be actively driven to rotate and a frictional force between the roller ROL which rotates and the display module DM may passively slide the display device DD along the sliding direction. In an embodiment, active sliding of the display module DM may passively rotate the roller ROL and allow the display device DD to slide in the sliding direction. Thus, the folding reliability of the electronic device EDa may be improved.

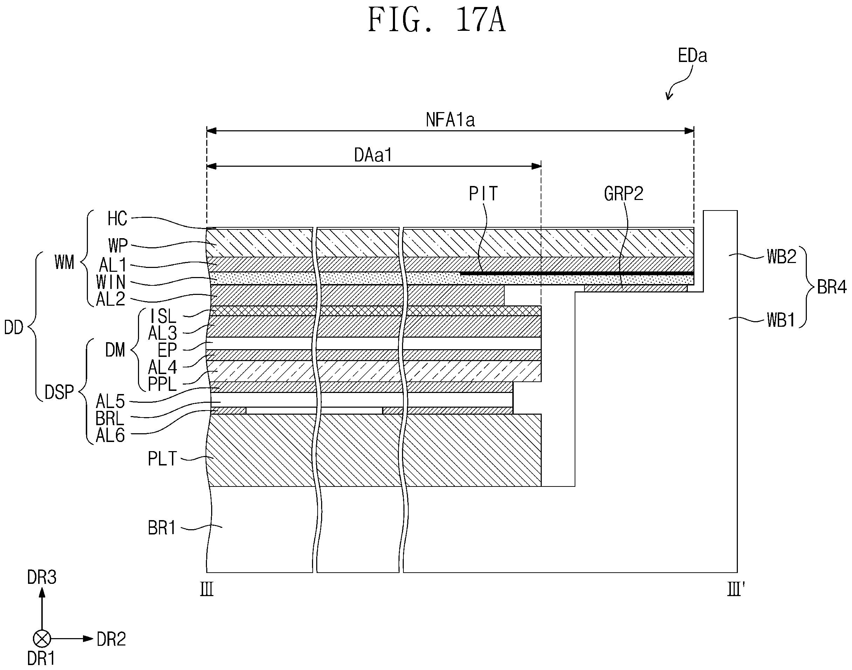

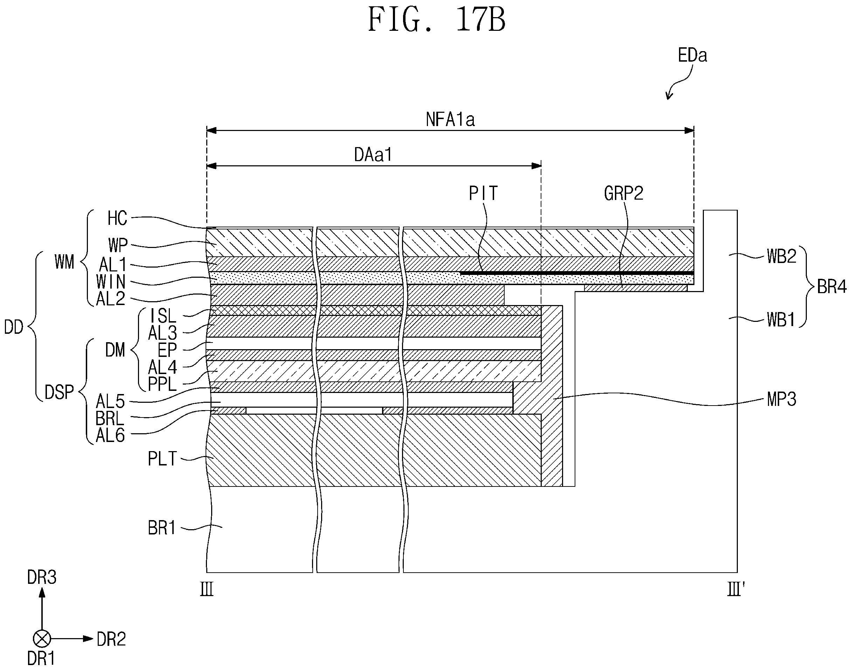

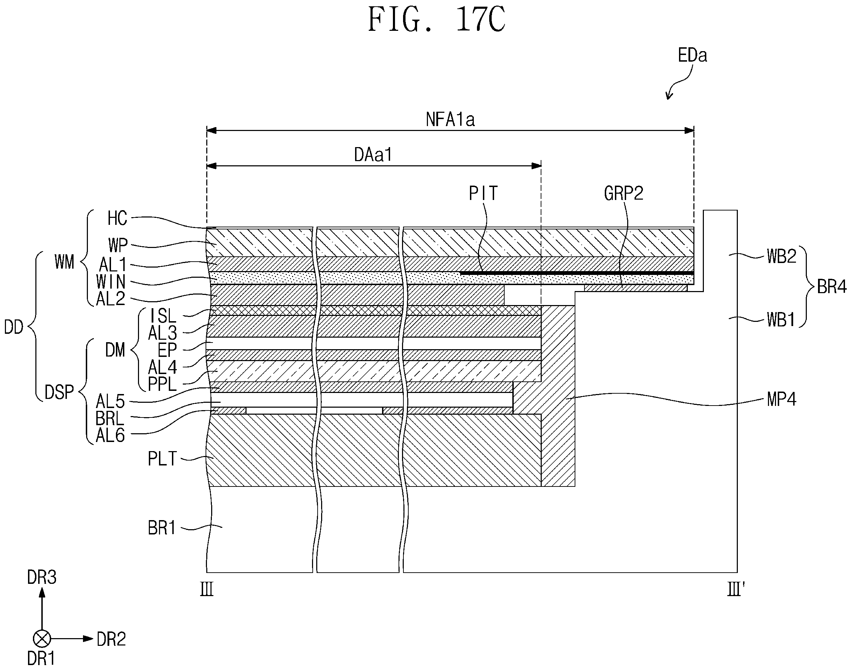

FIG. 17A is a cross-sectional view taken along line III-III' illustrated in FIG. 1A. FIG. 17B is a sectional view taken along line III-III' according to an embodiment of the present disclosure. FIG. 17C is a cross-sectional view taken along line III-III' according to an embodiment of the present disclosure.

FIGS. 17A to 17C are cross-sectional views of the electronic device EDa taken along a direction parallel to the folding axis FXa (refer to FIG. 1A).

FIGS. 17A to 17C are sectional views of the electronic device EDa as viewed in the first direction DR1.

FIGS. 17B and 17C are the same as FIG. 17A except for a third molding part MP3 and a fourth molding part MP4, and therefore only the third molding part MP3 and the fourth molding part MP4 will be described in FIGS. 17B and 17C.

The display device DD of FIGS. 17A to 17C is identical to the display device DD of FIG. 10 and therefore will be omitted from the description or will be briefly described.

For convenience of description, one of opposite sides of the electronic device EDa (e.g., a third edge portion) which face away from each other in the first direction DR1 will be described with reference to FIGS. 17A to 17C. However, the other one of the opposite sides of the electronic device EDa (e.g., the fourth edge portion) which face away from each other in the first direction DR1 may also have substantially the same structure.

Referring to FIGS. 3 and 17A, the bracket EDC may further include a fourth bracket BR4. The fourth bracket BR4 may be disposed on the first bracket BR1. The fourth bracket BR4 may be disposed adjacent to the periphery of the first bracket BR1.

The fourth bracket BR4 may extend from a virtual plane corresponding to the upper surface of the first bracket BR1 in the third direction DR3. Substantially, the first bracket BR1 and the fourth bracket BR4 may be integrally formed with each other.

The fourth bracket BR4 may include a first sidewall WB1 and a second sidewall WB2. The first sidewall WB1 may be disposed on the upper surface of the first bracket BR1. The first sidewall WB1 may extend from the upper surface of the first bracket BR1 in the third direction DR3.

For example, the first sidewall WB1 may have a rectangular shape when viewed in the second direction DR2. However, without being limited thereto, the first sidewall WB1 may have various shapes.

For example, the upper surface of the first sidewall WB1 may be located in a higher position than the upper surface of the impact absorbing layer ISL. For example, the upper surface of the first sidewall WB1 may be located in a lower position than the lower surface of the window WIN.

The second sidewall WB2 may be disposed on the upper surface of the first sidewall WB1. The second sidewall WB2 may be disposed adjacent to one of opposite sides of the first sidewall WB1 which face away from each other in the second direction DR2. The one side of the first sidewall WB1 in the second direction DR2 may be defined as a side facing away from the other side which faces the display device DD.

The second sidewall WB2 may extend from the upper surface of the first sidewall WB1 in the third direction DR3. Substantially, the first sidewall WB1 and the second sidewall WB2 may be integrally formed with each other.

When viewed in the first direction DR1, the width of the first sidewall WB1 in the second direction DR2 may be greater than the width of the second sidewall WB2 in the second direction DR2.

A partial region of the window WIN, a partial region of the first adhesive layer AL1, a partial region of the window protection layer WP, and a partial region of the hard coating layer HC which are disposed outward of the display module DM (e.g., extended further than an outer side surface of the display module DM) may be disposed over the first sidewall WB1. The partial region of the window WIN, the partial region of the first adhesive layer AL1, the partial region of the window protection layer WP, and the partial region of the hard coating layer HC which are disposed outward of the display module DM may overlap the first sidewall WB1.

A second adhesive part GRP2 as a second adhesive member may be disposed between the window WIN and the first sidewall WB1. The second adhesive part GRP2 may be directly disposed on the lower surface of the window WIN and the upper surface of the first sidewall WB1. Accordingly, the window WIN and the fourth bracket BR4 may be bonded to each other by the second adhesive part GRP2.

For example, the second adhesive part GRP2 may be a flexible adhesive. Accordingly, when the electronic device EDa is folded as illustrated in FIG. 1B, the window WIN may be movable in the first direction DR1 (e.g., the sliding direction) by a predetermined distance.

Referring to FIG. 17B, the electronic device EDa may further include the third molding part MP3. The third molding part MP3 may be disposed between the display unit DSP and the other side of the first sidewall WB1 and between the support plate PLT and the other side of the first sidewall WB1. The third molding part MP3 may cover one side of the display unit DSP and one side of the support plate PLT. The third molding part MP3 may not make contact with the other side of the first sidewall WB1 (e.g., the inner side surface of the first sidewall WB1). The third molding part MP3 may be spaced apart from the other side of the first sidewall WB1 by a predetermined distance in the first direction DR1. The one side of the display unit DSP and the one side of the support plate PLT may be defined as sides facing the other side of the first sidewall WB1.

The third molding part MP3 may cover the one side of the display unit DSP and the one side of the support plate PLT and may prevent infiltration of moisture into the display unit DSP and the support plate PLT. For example, the third molding part MP3 may include a resin. However, without being limited thereto, the third molding part MP3 may include other materials.

Referring to FIG. 17C, the fourth molding part MP4 may be disposed between the display unit DSP and the other side of the first sidewall WB1 and between the support plate PLT and the other side of the first sidewall WB1. The fourth molding part MP4 may cover the one side of the display unit DSP and the one side of the support plate PLT. The fourth molding part MP4 may be brought into contact with the other side of the first sidewall WB1 (e.g., the inner side surface of the first sidewall WB1).

The fourth molding part MP4 may cover the one side of the display unit DSP and the one side of the support plate PLT and may prevent infiltration of moisture into the display unit DSP and the support plate PLT. For example, the fourth molding part MP4 may include a resin. However, without being limited thereto, the fourth molding part MP4 may include other materials.

FIGS. 18A and 18B illustrate an electronic device EDc according to an embodiment of the present disclosure.

FIGS. 18A and 18B are perspective views of the electronic device EDc.

The electronic device EDc of FIGS. 18A and 18B may be substantially the same as the electronic device EDa of FIGS. 1A and 1B except for the folding direction, and therefore description of the electronic device EDc of FIGS. 18A and 18B will be focused on a difference from the electronic device EDa of FIGS. 1A and 1B.

Referring to FIGS. 18A and 18B, the electronic device EDc may include a folding region FAc and a plurality of non-folding regions NFA1c and NFA2c. The non-folding regions NFA1c and NFA2c may include the first non-folding region NFA1c and the second non-folding region NFA2c. The first non-folding region NFA1c and the second non-folding region NFA2c may be disposed to face away from each other in the first direction DR1. The folding region FAc may be disposed between the first non-folding region NFA1c and the second non-folding region NFA2c. The first non-folding region NFA1c, the folding region FAc, and the second non-folding region NFA2c may be arranged in the first direction DR1.

The first non-folding region NFA1c may be defined as the first region NFA1c. The second non-folding region NFA2c may be defined as the second region NFA2c. The folding region FAc may be defined as the third region FAc.

The electronic device EDc may be a foldable electronic device EDc which is folded or unfolded. For example, the folding region FAc may be bent about a folding axis FXc parallel to the second direction DR2, and the electronic device EDc may be folded accordingly. The folding axis FXc may be defined as a long axis parallel to long sides of the electronic device EDc.

An upper surface of the electronic device EDc may be defined as a display surface DSc, and the display surface DSc may have a plane defined by the first direction DR1 and the second direction DR2. Images IM generated by the electronic device EDc may be provided to a user through the display surface DSc.

The display surface DSc may include a display region DAc and a non-display region NDAc around the display region DAc. The display region DAc may be defined as the front surface of the electronic device EDc. The display region DAc may display an image IM, and the non-display region NDAc may not display an image IM.

The display region DAc, when viewed from above the plane, may be divided into a first display region DAc1 and a second display region DAc2 with respect to the folding axis FXc. The first display region DAc1 may overlap the first region NFA1c. The second display region DAc2 may overlap the second region NFA2c.

When the electronic device EDc is folded, the first non-folding region NFA1c and the second non-folding region NFA2c may not face each other. The first display region DAc1 and the second display region DAc2 may not face each other. The electronic device EDc may be out-folded such which the display surface DSc is exposed to the outside.

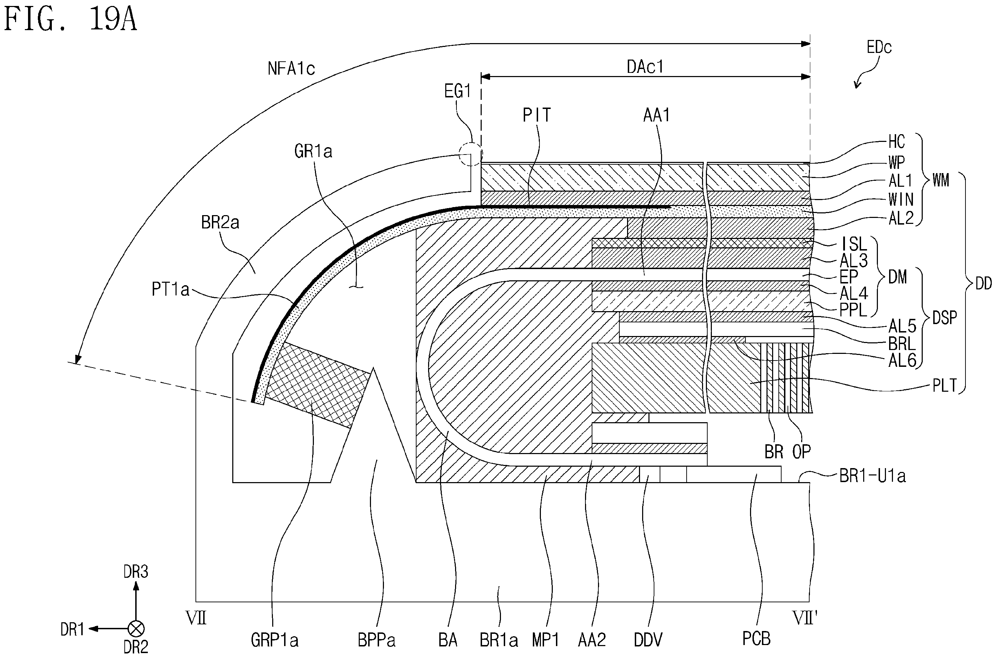

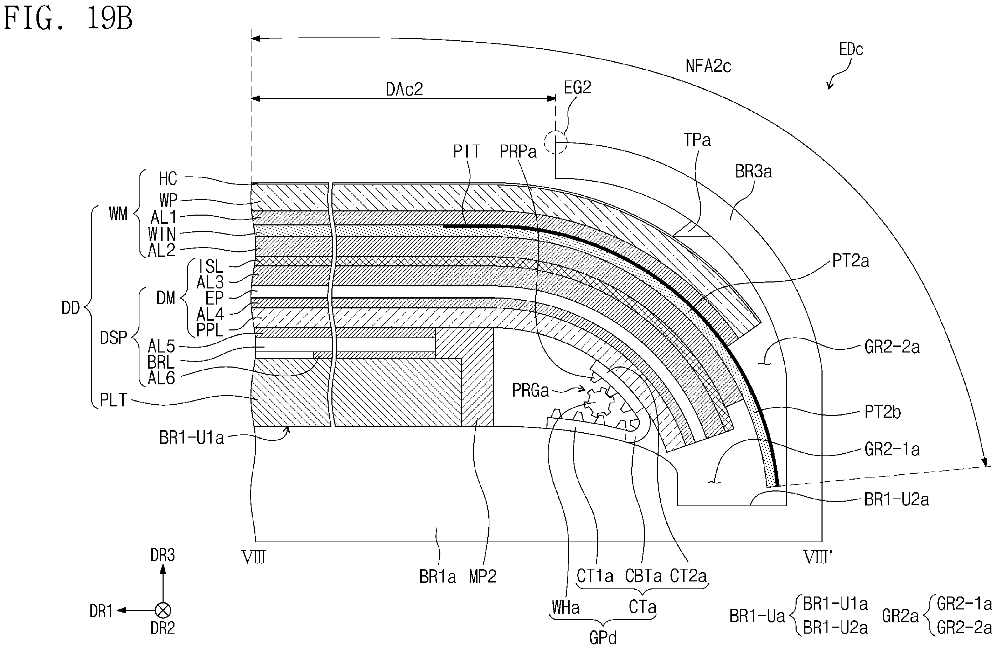

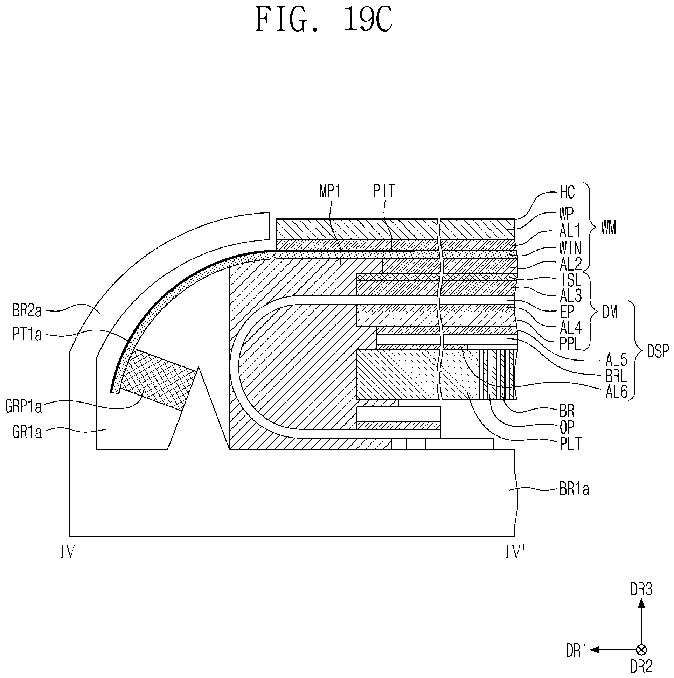

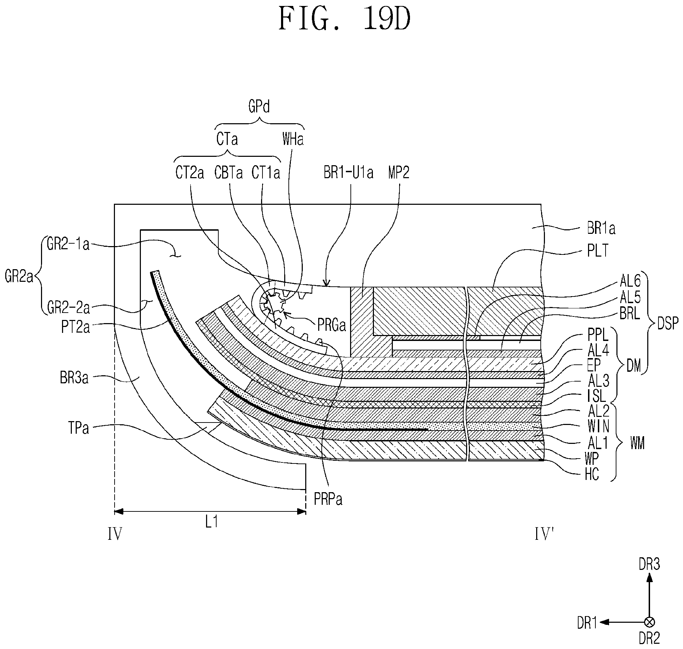

FIG. 19A is a cross-sectional view taken along line VII-VII' illustrated in FIG. 18A. FIG. 19A illustrates a structure at a first edge portion of the electronic device EDc (refer to FIG. 18A) viewed in the second direction DR2. FIG. 19B is a cross-sectional view taken along line VIII-VIII' illustrated in FIG. 18A. FIG. 19B illustrates a structure at a second edge portion of the electronic device EDc (refer to FIG. 18A) viewed in the second direction DR2. FIGS. 19C and 19D are cross-sectionals view taken along line IX-IX' illustrated in FIG. 18B.

FIGS. 19D is a view of the structure in FIG. 19B which inverted and facing the structure in FIG. 19A, to each be disposed at the first edge portion of the electronic device EDd which is folded in FIG. 18B. While the views in FIGS. 19C and 19D are shown separated for illustration, it will be understood that the structures of FIGS. 19C and 19D may be directly adjacent to each other at the first edge portion of the electronic device EDd folded in FIG. 18B.

FIGS. 19A and 19B are cross-sectional views of the electronic device EDc in an unfolded state, and FIG. 19C is a sectional view of the electronic device EDc in an out-folded state. In the electronic device EDc which is unfolded (FIG. 18A) or which is out-folded (FIG. 18B), extended portions of various layers within the display device DD bent within the bracket EDC.

A display device DD, a first bracket BR1a, a second bracket BR2a, a third bracket BR3a, a first adhesive part GRP1a, and a tip portion TPa of FIGS. 19A to 19D are substantially the same as the display device DD, the first bracket BR1, the second bracket BR2, the third bracket BR3, the first adhesive part GRP1, and the tip portion TP illustrated in FIGS. 13A and 13B and therefore will be omitted from the description or will be briefly described.

Referring to FIG. 19A, a first molding part MP1 may be disposed on one side of the display device DD. The first molding part MP1 may cover a display unit DSP, a support plate PLT, and a bending portion BA. The first molding part MP1 may fix the positions of the support plate PLT, the display unit DSP, and the bending portion BA.

Accordingly, when the electronic device EDc is folded, the first molding part MP1 may prevent movement or slipping of edges of a display module DM, a panel protection layer PPL, a fifth adhesive layer AL5, a barrier layer BRL, a sixth adhesive layer AL6, and the support plate PLT.

An extended portion of a window WIN may be disposed in a first receiving groove GR1a. The periphery of the window WIN which extends further than end surfaces of various layers may define the extended portion and be disposed in the first receiving groove GR1a. A portion of the window WIN which overlaps the second bracket BR2a may be defined as a first portion PT1a.

The portion of the window WIN may be bent in a curved shape. The portion of the window WIN may be disposed in a curved shape in the first receiving groove GR1a. The first portion PT1a may be disposed in a curved shape in the first receiving groove GR1a.

A bracket EDC (refer to FIG. 3) may include a protrusion BPPa. The protrusion BPPa may be disposed on the first bracket BR1a. The protrusion BPPa may be disposed on an upper surface BR1-U1a of the first bracket BR1a. The protrusion BPPa may extend from the upper surface BR1-U1a of the first bracket BR1a in the third direction DR3. Substantially, the protrusion BPPa may be integrally formed with the first bracket BR1a.

The first adhesive part GRP1a may be disposed between the protrusion BPPa and the first portion PT1a. One portion of the first adhesive part GRP1a may be attached to the lower surface of the first portion PT1a. Another portion of the first adhesive part GRP1a may be attached to one of opposite side surfaces of the protrusion BPPa which face away from each other in the first direction DR1. The one side surface of the protrusion BPPa may be defined as a side surface facing away from the other side surface which faces the first molding part MP1. The first portion PT1a and the protrusion BPPa may be bonded to each other by the first adhesive part GRP1a. The curved shape of the first portion PT1a may be maintained by the first adhesive part GRP1a.

Referring to FIG. 19B, a second molding part MP2 may be disposed on an opposite side of the display device DD. The second molding part MP2 may be disposed on an opposite side of the fifth adhesive layer AL5, an opposite side of the barrier layer BRL, an opposite side of the sixth adhesive layer AL6, and an opposite side of the support plate PLT. The second molding part MP2 may cover the opposite side of the fifth adhesive layer AL5, the opposite side of the barrier layer BRL, the opposite side of the sixth adhesive layer AL6, and the opposite side of the support plate PLT. The opposite side of the fifth adhesive layer AL5, the opposite side of the barrier layer BRL, the opposite side of the sixth adhesive layer AL6, and the opposite side of the support plate PLT may be defined as sides facing the third bracket BR3a.

The support plate PLT may be disposed on an upper surface 1-1 BR1-U1a of the first bracket BR1a. The second molding part MP2 may be disposed on the upper surface 1-1 BR1-U1a of the first bracket BR1a.

Extended portions of a window module WM and the display module DM may be disposed in a second receiving groove GR2a when the display device DD is disposed on the upper surface 1-1 BR1-U1a of the first bracket BR1a. The respective extended portions of the window module WM and the portion of the display module DM may be disposed in a receiving groove 2-2 GR2-2a. The peripheries of the window module WM and the display module DM which are extended further than side surfaces of various layers may define the extended portions and be disposed in the receiving groove 2-2 GR2-2a. A portion of the window WIN which overlaps the third bracket BR3a may be defined as a second portion PT2a.

The portion of the window module WM and the portion of the display module DM may be bent in a curved shape. The portion of the window module WM and the portion of the display module DM may be disposed in a curved shape in the receiving groove 2-2 GR2-2a. The second portion PT2a of the window WIN may be disposed in a receiving groove 2-1 GR2-1a. The second portion PT2a may be disposed in a curved shape in the receiving groove 2-1 GR2-1a and the receiving groove 2-2 GR2-2a.

The electronic device EDc may further include a fourth guide part GPd. The fourth guide part GPd may be disposed between the first bracket BR1a and the panel protection layer PPL. One portion of the fourth guide part GPd may be disposed on the upper surface BR1-Ua of the first bracket BR1a. The upper surface BR1-Ua of the first bracket BR1a may include an upper surface 1-1 BR1-U1a as a first upper surface portion and an upper surface 1-2 BR1-U2a as a second upper surface portion.

The fourth guide part GPd may include a track CTa and a wheel WHa disposed inside the track CTa bent in a curved shape. One portion of the track CTa may be disposed on the upper surface BR1-Ua of the first bracket BR1a, and another portion of the track CTa may be disposed on the lower surface of the panel protection layer PPL.

The track CTa may include a first track portion CT1a, a bent track portion CBTa, and a second track portion CT2a. The first track portion CT1a may be defined as a portion of the track CTa disposed on the upper surface BR1-Ua of the first bracket BR1a. The second track portion CT2a may be defined as a portion of the track CTa which is disposed on the lower surface of the panel protection layer PPL to face the first track portion CT1a. The bent track portion CBTa may be defined as a portion of the track CTa which is bent and which connects the first track portion CT1a and the second track portion CT2a to each other.

When viewed in the second direction DR2, the first track portion CT1a may be longer than the second track portion CT2a.

Each of the first track portion CT1a, the second track portion CT2a, and the bent track portion CBTa may include track protrusions PRPa.

The track protrusions PRPa may be disposed on surfaces of the first track portion CT1a and the second track portion CT2a which face each other. The track protrusions PRPa may be disposed on a surface of the bent track portion CBTa which faces the wheel WHa.

The wheel WHa may be disposed between the first track portion CT1a and the second track portion CT2a. The wheel WHa may be connected to part of the first track portion CT1a, part of the second track portion CT2a, and the bent track portion CBTa.

Wheel protrusions PRGa may be disposed on the outer surface of the wheel WHa. The wheel protrusions PRGa may be spaced apart from each other at predetermined intervals along the outer surface of the wheel WHa.

The track protrusions PRPa of the first track portion CT1a, the second track portion CT2a, and the bent track portion CBTa may be engaged with the wheel protrusions PRGa. Accordingly, the wheel WHa may be rotated about a rotational axis parallel to the second direction DR2 when the track protrusions PRP move along the outer surface of the wheel WHa.

The electronic device EDc may further include the tip portion TPa. The tip portion TPa may be disposed on the inner surface of the third bracket BR3a. The tip portion TPa may be disposed adjacent to an upper portion of the third bracket BR3a.

The tip portion TPa may prevent infiltration of foreign matter into the second receiving groove GR2a. The infiltration of the foreign matter into the second receiving groove GR2a may be blocked by the tip portion TPa.

Referring to FIGS. 18B, 19B, 19C and 19D, when the electronic device EDc is out-folded, the third bracket BR3a may be disposed under the second bracket BR2a.

When the electronic device EDc is out-folded, the display unit DSP and the window module WM may move from a first position inside the the receiving groove 2-1 GR2-1a (FIG. 19B) to a second position outside of the receiving groove 2-1 GR2-1a (FIG. 19D). As the display unit DSP and the window module WM move out of the receiving groove 2-1 GR2-1a, the area of the second portion PT2a overlapping the third bracket BR3a may be decreased. That is, an exposed area of the second portion PT2a which corresponds to an area between the inner side surfaces of the bracket EDC at the first edge EG1 and the second edge EG2 may be increased.

When the display unit DSP and the window module WM move from the receiving groove 2-1 GR2-1a to the outside thereof, the length of the second track portion CT2a extended along the display unit DSP may be increased, and the length of the first track portion CT1a may be decreased. Specifically, an unattached portion of the first track portion CT1a initially disposed along the first bracket BR1a may move to extend along the display unit DSP, by movement along the outer surface of the wheel WHa.

Although not illustrated, part of the second track portion CT2a may be moved onto the first bracket BR1a along the outer surface of the wheel WHa when the electronic device EDc is changed from the out-folded state to the unfolded state. At this time, the length of the first track portion CT1a may be increased, and the length of the second track portion CT2a may be decreased.

Even though the electronic device EDc repeatedly performs out-folding and unfolding operations, the fourth guide part GPd may enable the display unit DSP and the window module WM to move into the the receiving groove 2-1 GR2-1a without moving out of the first and third brackets BR1a and BR3a and being visible from outside thereof. Accordingly, the window module WM and the display module DM may not be separated out of the bracket EDC (refer to FIG. 3). Thus, the folding reliability of the electronic device EDc may be improved.

Referring to FIGS. 15A to 15E, 19B, and 19D, the electronic device EDc of FIGS. 19B and 19D is illustrated as including the fourth guide part GPd. However, the present disclosure is not limited thereto. For example, although not illustrated, the electronic device EDc of FIGS. 19B, 19C and 19D may include the second guide part GPb illustrated in FIGS. 15A to 15E. In this case, the second guide part GPb may be in the second state when the electronic device EDc is in the unfolded state. The second guide part GPb may be in the first state when the electronic device EDc is in the out-folded state.

Referring to FIGS. 16, 19B, 19C and 19D, although not illustrated, the electronic device EDc illustrated in FIGS. 19B, 19C and 19D may include the third guide part GPc illustrated in FIG. 16. In this case, the third guide part GPc may be rotated in the counterclockwise direction about a rotational axis parallel to the second direction DR2 when the electronic device EDc is changed from the unfolded state to the out-folded state.

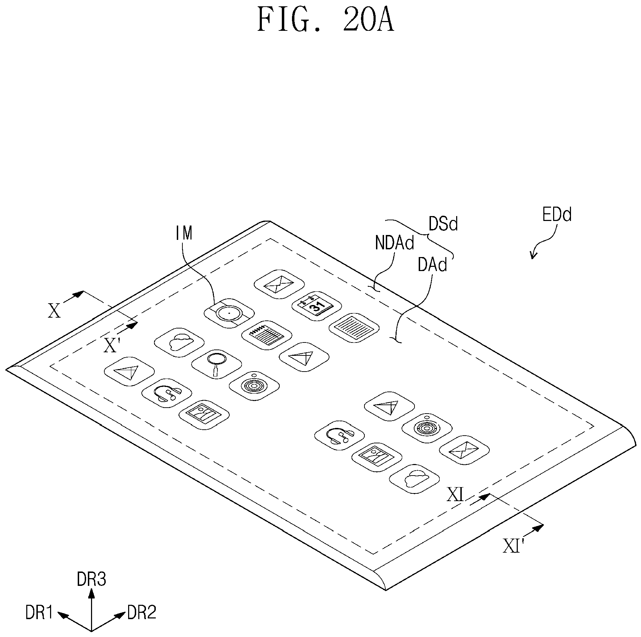

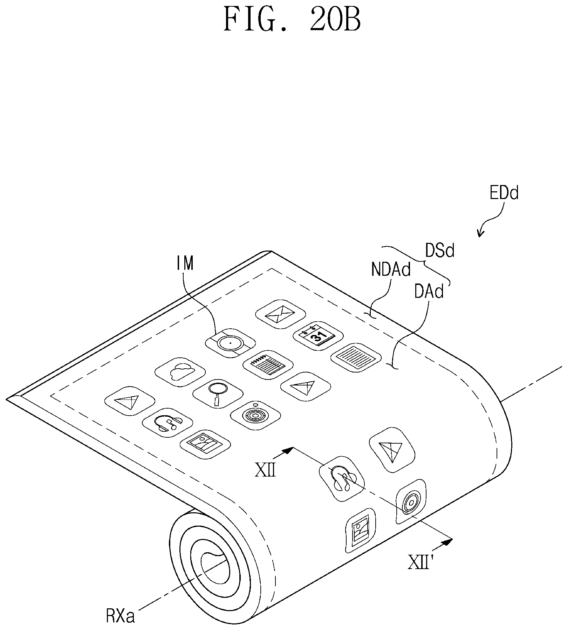

FIGS. 20A and 20B are views for explaining an electronic device according to an embodiment of the present disclosure.

FIGS. 20A and 20B are perspective views of the electronic device EDd.

FIG. 20B is a view illustrating a wound state of the electronic device EDd illustrated in FIG. 20A.

Referring to FIGS. 20A and 20B, the electronic device EDd may have a rectangular shape with long sides extending in the first direction DR1 and short sides extending in the second direction DR2. However, without being limited thereto, the electronic device EDd may have various shapes such as a circular shape, a polygonal shape, and the like.

An upper surface of the electronic device EDd may be defined as a display surface DSd, and the display surface DSd may have a plane defined by the first direction DR1 and the second direction DR2. Images IM generated by the electronic device EDd may be provided to a user through the display surface DSd.

The display surface DSd may include a display region DAd and a non-display region NDAd around the display region DAd. The display region DAd may be defined as the front surface of the electronic device EDd. The display region DAd may display an image IM, and the non-display region NDAd may not display an image IM.

Referring to FIGS. 20A and 20B, the electronic device EDd may be rolled into the shape of a roll (e.g., having a rolled shape). The electronic device EDd may be rolled about a rolling axis RXa parallel to the second direction DR2. The electronic device EDd may be rolled about the rolling axis RXa, in the first direction DR1 as a rolling direction. The electronic device EDd may be out-rolled such that the display surface DSd faces toward the outside.

When the electronic device EDd is out-rolled, one side of the electronic device EDd in the first direction DR1 (e.g., a first edge portion) may be spaced apart from the rolling axis RXa, and an opposite side of the electronic device EDd in the first direction DR1 may be adjacent to the rolling axis RXa (e.g., closer to the rolling axis RXa than the one side as a second edge portion). Rolling of the electronic device EDd with respect to the rolling axis RXa may begin at the second edge portion. Hereinafter, the one side of the electronic device EDd in the first direction DR1 may be defined as a first region, and the opposite side of the electronic device EDd in the first direction DR1 may be defined as a second region. When the electronic device EDd is rolled, the second region may be located in the center of the electronic device EDd which is rolled. The electronic device EDd may be rolled about the rolling axis RXa, starting from the second region.

For example, when an initial portion of the electronic device EDd is rolled starting at the second edge portion, the second region of the electronic device EDd may be in a bent or curved state, while a remaining portion of the electronic device EDd up to the first region of the electronic device EDd may be in a flat state. However, the present disclosure is not limited thereto, and when the electronic device EDd is completely rolled, the first region of the electronic device EDd may also be in a bent or rolled state.

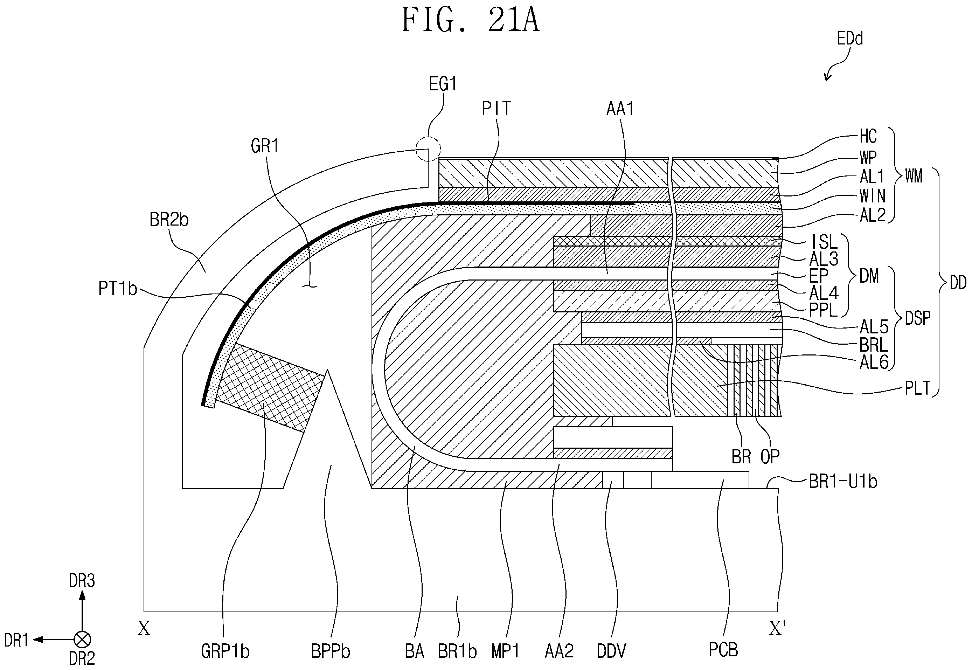

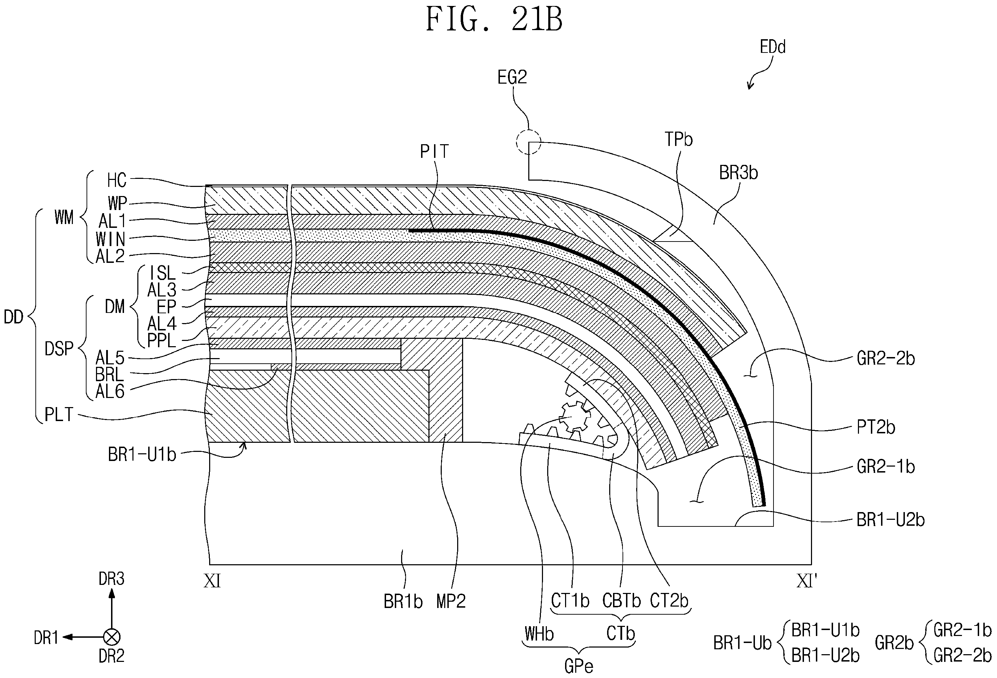

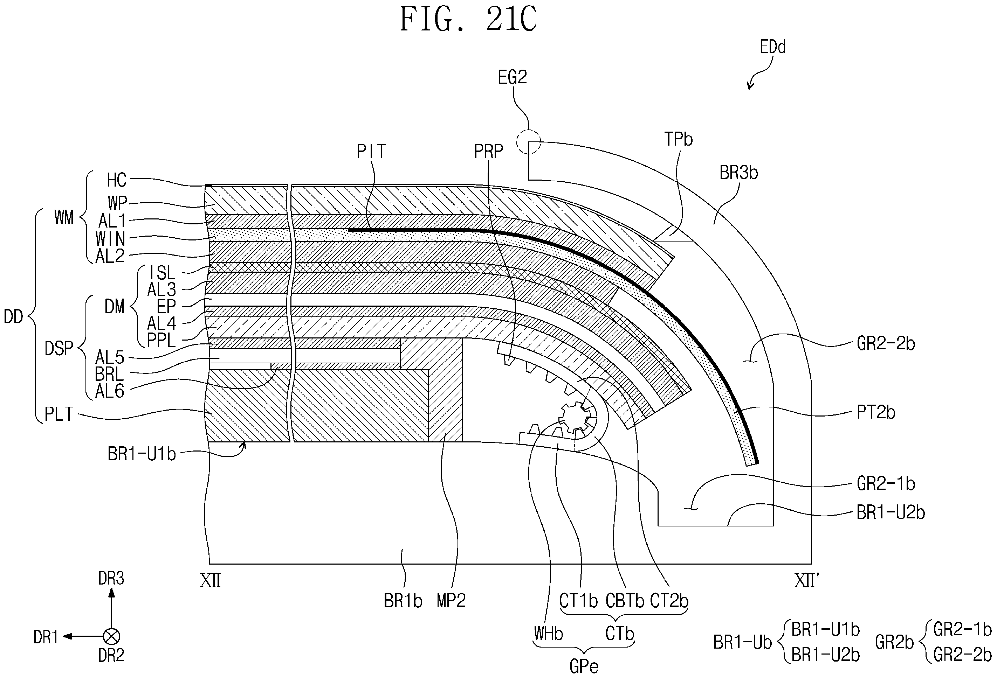

FIG. 21A is a cross-sectional view taken along line X-X' illustrated in FIG. 20A (e.g., a first unrolled edge portion). FIG. 21B is a cross-sectional view taken along line XI-XI' illustrated in FIG. 20A (e.g., a second unrolled edge portion). FIG. 21C is a cross-sectional view taken along line XII-XII' illustrated in FIG. 20B (e.g., a rolled edge portion).

FIGS. 21A and 21B are cross-sectional views of unrolled edge portions the electronic device EDd in an unrolled state, and FIG. 21C is a sectional view of the electronic device EDd in a rolled state.

FIG. 21C illustrates only a portion adjacent to the periphery of the second region. While the orientation of the structure in FIG. 21C is substantially similar to the orientation of FIG. 21B, it will be understood that the structure in FIG. 21C may be rotated about the rotation axis RXa into a different orientation.

Components illustrated in FIG. 21A are substantially the same as the components illustrated in FIG. 11 and the components illustrated in FIG. 19A except for the first region NFA1a (refer to FIG. 11). Therefore, for convenience of description, description of FIG. 21A will be omitted.

A display device DD, a first bracket BR1b, a third bracket BR3b, a first adhesive part GRP1b, a protrusion BPPb and a tip portion TPb illustrated in FIGS. 21B and 21C are substantially the same as the display device DD, the first bracket BR1a, the third bracket BR3a, the first adhesive part GRP1a, the protrusion BPPa and the tip portion TPa illustrated in FIGS. 19B and 19C and therefore will be omitted from the description or will be briefly described. An upper surface BR1-Ub of the first bracket BR1b may include an upper surface 1-1 BR1-U1b as a first upper surface portion and an upper surface 1-2 BR1-U2b as a second upper surface portion.

Referring to FIG. 21B, a fifth guide part GPe may be disposed between a display unit DSP and the first bracket BR1b. One portion of the fifth guide part GPe may be connected to an upper surface BR1-Ub of the first bracket BR1b. Another portion of the fifth guide part GPe may be connected to a lower surface of a panel protection layer PPL.

The fifth guide part GPe may include a track CTb and a wheel WHb disposed inside the track CTb bent in a curved shape. One portion of the track CTb may be disposed on the upper surface BR1-Ub of the first bracket BR1b, and another portion of the track CTb may be disposed on the lower surface of the panel protection layer PPL.

The track CTb may include a first track portion CT1b, a bent track portion CBTb, and a second track portion CT2b. The first track portion CT1b may be defined as a portion of the track CTb disposed on the upper surface BR1-Ub of the first bracket BR1b. The second track portion CT2b may be defined as a portion of the track CTb which is disposed on the lower surface of the panel protection layer PPL to face the first track portion CT1b. The bent track portion CBTb may be defined as a portion of the track CTb which is bent and which connects the first track portion CT1b and the second track portion CT2b to each other.

When the electronic device EDd is in the unrolled state, the first track portion CT1b may be longer than the second track portion CT2b.

Referring to FIGS. 21A to 21C, when the electronic device EDd is rolled, a first molding part MP1 may fix one side of the display unit DSP and one side of a support plate PLT at a same side, e.g., adjacent to the first unrolled edge portion. Accordingly, when the electronic device EDd is rolled, the one side of the display unit DSP and the one side of the support plate PLT may not slip and may be fixedly disposed. The one side of the display unit DSP and the one side of the support plate PLT may be defined as sides adjacent to a second bracket BR2b. A portion of the window WIN which overlaps the second bracket BR2b may be defined as a first portion PT1b.

When the electronic device EDd is rolled, an opposite side of the display unit DSP and an opposite side of a window module WM may slip or slide in position, e.g., adjacent to the second edge portion to define the rolled edge portion. The opposite side of the display unit DSP and the opposite side of the window module WM may be moved by the slip. The opposite side of the display unit DSP and the opposite side of the window module WM may move from inside a first sub-groove GR2-1b of a second receiving groove GR2b to the outside of the first sub-groove GR2-1b. That is, an end of the window module WM may move from the first sub-groove GR2-1b to a second sub-groove GR2-2b. When the electronic device EDd is out-rolled, the area of a second portion PT2b may be decreased. The opposite side of the display unit DSP and the opposite side of the window module WM may be defined as sides facing the third bracket BR3b.

As the display unit DSP and the window module WM move, the track CTb connected to the display unit DSP may be moved along the outer surface of the wheel WHb. Specifically, part of the first track portion CT1b may be moved onto the lower surface of the panel protection layer PPL along the outer surface of the wheel WHb. Accordingly, when the electronic device EDd is rolled, the length of the first track portion CT1b may be decreased. When the electronic device EDd is rolled, the length of the second track portion CT2b may be increased.

Even though the electronic device EDd repeatedly performs rolling and unrolling operations, the fifth guide part GPe may enable the display unit DSP and the window module WM to move along the second receiving groove GR2b without moving out of the first and third brackets BR1b and BR3b. Accordingly, the window module WM and a display module DM may not be separated out of a bracket EDC (refer to FIG. 3). Thus, the rolling reliability of the electronic device EDd may be improved.

Although the electronic device EDd of FIG. 21C is illustrated as including the fifth guide part GPe, the present disclosure is not limited thereto. For example, although not illustrated, the electronic device EDd illustrated in FIG. 21C may include the second guide part GPb illustrated in FIGS. 15A to 15E. In this case, the second guide part GPb may be in the first state when the electronic device EDd is in an out-rolled state. The second guide part GPb may be in the second state when the electronic device EDd is in an unrolled state.

Although not illustrated, the electronic device EDd illustrated in FIG. 21C may include the third guide part GPe illustrated in FIG. 16. In this case, the third guide part GPc may be rotated in the counterclockwise direction about a rotational axis parallel to the second direction DR2 when the electronic device EDd is changed from the unrolled state to the rolled state.

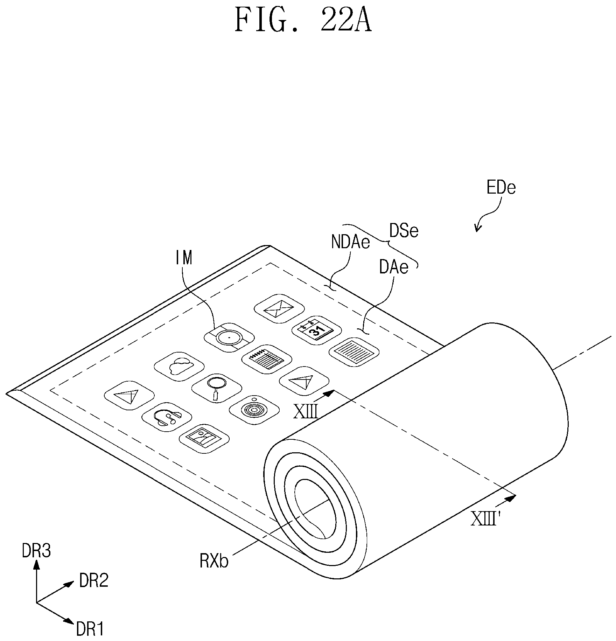

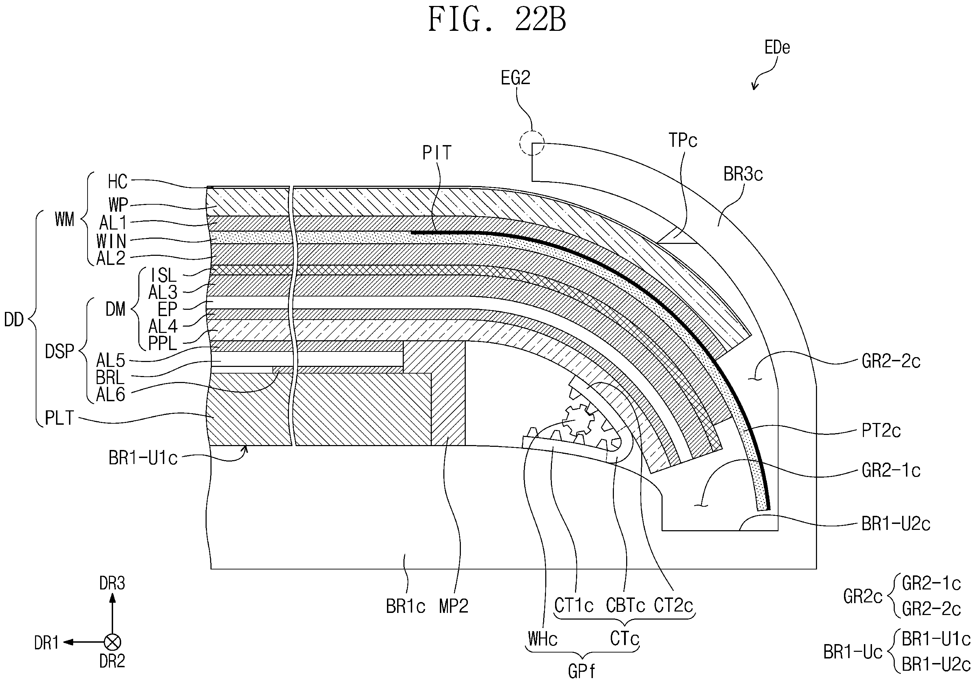

FIGS. 22A and 22B are views for explaining an electronic device EDe according to an embodiment of the present disclosure.

FIG. 22A is a perspective view of the electronic device EDe which is in-rolled, and FIG. 22B is a cross-sectional view taken along line XIII-XIII' illustrated in FIG. 22A which is at the rolled edge portion.

For convenience of description, only a portion of the electronic device EDe of FIG. 22A is illustrated in FIG. 22B.

The electronic device EDe illustrated in FIG. 22A is substantially the same as the electronic device EDd illustrated in FIG. 20A except for the rolling direction, and therefore the following description will be focused on the difference. The display surface DSe may include a display region DAe and a non-display region NDAe around the display region DAe.

A display device DD, a first bracket BR1c, a third bracket BR3c, a guide part GPf, and a tip portion TPc illustrated in FIG. 22B are substantially the same as the display device DD, the first bracket BR1b, the third bracket BR3b, the fifth guide part GPe, and the tip portion TPb illustrated in FIG. 21B and therefore will be omitted from the description or will be briefly described.

Referring to FIG. 22A, the electronic device EDe may be rolled into the shape of a roll. The electronic device EDe may be rolled about a rolling axis RXb parallel to the second direction DR2. The electronic device EDe may be rolled about the rolling axis RXb in the first direction DR1. The electronic device EDe may be in-rolled such that a display surface DSe does not face toward the outside.

When the electronic device EDe is in-rolled, one side at a first edge portion of the electronic device EDe in the first direction DR1 may be spaced apart from the rolling axis RXb, and an opposite side at a second edge portion of the electronic device EDe in the first direction DR1 may be adjacent to the rolling axis RXb. Hereinafter, the one side of the electronic device EDe in the first direction DR1 may be defined as a first region, and the opposite side of the electronic device EDe in the first direction DR1 may be defined as a second region. When the electronic device EDe is rolled, the second region may be defined in the center of the rolled electronic device EDe. The electronic device EDe may be rolled starting from the second region.

For example, when the electronic device EDe is in-rolled, the second region of the electronic device EDe may be in a bent state. The first region of the electronic device EDe and a remaining portion between the bent state and the first edge portion may be in a flat state. However, the present disclosure is not limited thereto, and when the electronic device EDe is completely rolled, the first region of the electronic device EDe may also be in a bent state.

Referring to FIGS. 22A and 22B, when the electronic device EDe is in-rolled, an opposite side of a display unit DSP and an opposite side of a window module WM may slip. The opposite side of the display unit DSP and the opposite side of the window module WM may be moved by the slip. The opposite side of the display unit DSP and the opposite side of the window module WM may be moved along a second receiving groove GR2c such as into a first sub-groove GR2-1c from a second sub-groove GR2-2c. The area of a second portion PT2c overlapping the third bracket BR3c may be increased. The opposite side of the display unit DSP and the opposite side of the window module WM may be defined as sides facing the third bracket BR3c.

As the display unit DSP and the window module WM move, a track CTc connected to the display unit DSP may be moved along an outer surface of a wheel WHc. The track CTc may include a first track portion CT1c, a bent track portion CBTc, and a second track portion CT2c. Specifically, part of a second track portion CT2c may be moved onto an upper surface BR1-Uc of the first bracket BR1c along the outer surface of the wheel WHc. The upper surface BR1-Uc of the first bracket BR1c may include an upper surface 1-1 BR1-U1c as a first upper surface portion and an upper surface 1-2 BR1-U2c as a second upper surface portion. Accordingly, when the electronic device EDe is rolled, the length of the second track portion CT2c may be decreased. When the electronic device EDe is rolled, the length of a first track portion CT1c may be increased.

Even though the electronic device EDe repeatedly performs rolling and unrolling operations, the sixth guide part GPf may enable the display unit DSP and the window module WM to move along the second receiving groove GR2c without moving out of the first and third brackets BR1c and BR3c. Accordingly, the window module WM and a display module DM may not be separated out of a bracket EDC (refer to FIG. 3). Thus, the rolling reliability of the electronic device EDe may be improved.

Referring to FIGS. 15A to 15E, 22A, and 22B, the electronic device EDe of FIGS. 22A and 22B is illustrated as including the sixth guide part GPf. However, the present disclosure is not limited thereto. For example, although not illustrated, the electronic device EDe illustrated in FIGS. 22A and 22B may include the second guide part GPb illustrated in FIGS. 15A to 15E. In this case, the second guide part GPb may be in the second state when the electronic device EDe is in an in-rolled state. The second guide part GPb may be in the first state when the electronic device EDe is in an unrolled state.

Referring to FIGS. 16, 22A, and 22B, although not illustrated, the electronic device EDe illustrated in FIGS. 22A and 22B may include the third guide part GPc illustrated in FIG. 16. In this case, the third guide part GPc may be rotated in the clockwise direction about a rotational axis parallel to the second direction DR2 when the electronic device EDe is changed from the unrolled state to the in-rolled state.

In an embodiment, a display device includes a display panel foldable about a folding axis, the display panel including a first panel portion in which the folding axis is defined, a bending panel portion at which the display panel is bent, and a second panel portion arranged in a first direction, the folding axis of the display panel extended in a second direction crossing the first direction, a window foldable together with the display panel having the bending panel portion which is bent, the window including a first window portion adjacent to the bending panel portion and a second window portion which is spaced apart from the first window portion along the first direction, and a bracket in which the display panel and the window are received, the bracket including a first bracket corresponding to the first panel portion, the bending panel portion and the second panel portion, a second bracket which extends from the first bracket, toward the window, and covers the first window portion, and a third bracket which extends from the first bracket, toward the window, is spaced apart from the first bracket along the first direction and covers the second window portion. Folding and unfolding of the display panel about the folding axis includes movement of the second window portion along the first direction, within the bracket.

Within the bracket, a first receiving groove may be defined by the first bracket with the second bracket, a second receiving groove may be defined by the first bracket with the third bracket, the first window portion may extend along the second bracket and into the first receiving groove, along the first direction, and the second window portion may extend along the third bracket and into the second receiving groove, and the folding and unfolding of the display panel may move the second window portion along the third bracket, within the second receiving groove.

Further within the bracket, a protrusion may be connected to the bracket at an upper surface of the first bracket, the first receiving groove may be extended between the protrusion and the second bracket, and a first adhesive member may bond the first window portion to the first bracket, at the protrusion.

An edge of the third bracket may be furthest from the first bracket and a length of the third bracket may extend from the edge of the third bracket and overlap the window, a gap may be defined between the length of the third bracket and the window which is overlapped by the length, the gap may be open to outside the display device at the edge, and a tip portion may be within the gap.

A guide may include a wheel between the window and the first bracket, and a track which is engaged with the wheel and moveable along the wheel. The track may include a first track portion between the wheel and the first bracket, a second track portion between the wheel and the window, and a bent track portion which connects the first track portion and the second track portion to each other. The display panel which is unfolded may include the first track portion having a length extended along the first bracket, the second track portion having a length extended along the window, and within the second receiving groove, the second window portion having a length extended along the third bracket.

In-folding of the display panel may include the first display region and the second display region of the first panel portion facing each other, the length of the first track portion increased, the length of the second track portion decreased, and within the second receiving groove, the second window portion moved toward the first bracket and having the length of the second window portion increased (structure in FIG. 12 to structure in FIG. 13B, for example).

Out-folding of the display panel may include the first display region and the second display region of the first panel portion facing away from each other, the length of the first track portion decreased, the length of the second track portion increased, and within the second receiving groove, the second window portion moved away from the first bracket and having the length of the second window portion decreased (structure in FIG. 19B to structure in FIG. 19D, for example).

A guide may include a first guide plate which is connected to the first bracket and defines a guide groove of the first guide plate, and a second guide plate which is connected to the second window portion, the second guide plate including a guide rib moveable along the guide groove, in the first direction. The display panel which is unfolded may include the guide rib having a length within the guide groove. In-folding of the display panel may include the length of the guide rib decreased, and within the second receiving groove, the second window portion moved toward the first bracket and having the length of the second window portion increased (structure in FIG. 15A to structure in Fig. 15E, for example).

A guide may include a roller between the second window portion and the first bracket, and the display panel which is unfolded may include within the second receiving groove, the second window portion having a length extended along the third bracket, the length extended from the roller to an end of the window at the second window portion. In-folding of the display panel may include within the second receiving groove, the second window portion moved along the roller, toward the first bracket, and having the length of the second window portion (structure in FIG. 16, for example).

In an embodiment, a display device may include a display panel including a display region at which the display panel is rollable, a window rollable together with the display panel, the window including a first window portion and a second portion spaced apart from each other in a first direction, and a bracket in which the display panel and the window are received, the bracket including a first bracket corresponding to display region, the first window portion and the second window portion, a second bracket which extends from the first bracket and along which the first window portion extends, a third bracket which extends from the first bracket, is opposite to the second bracket along the first direction, and along which the second window portion extends to have a length overlapping the third bracket, a first receiving groove defined by the first bracket with the second bracket and into which the first window portion extends, and a second receiving groove defined by the first bracket with the third bracket and into which the second window portion extends. Rolling and unrolling (or in-rolling and out-rolling) of the display panel includes varying of the length of the second window portion which overlaps the third bracket.

According to the embodiments of the present disclosure, when the electronic device EDa is folded, one of the opposite sides of the display panel DP which face away from each other in the first direction DR1, may be curvedly moved along a receiving space in a housing (e.g., the bracket EDC). Accordingly, the width of the bracket EDC which is defined along a sliding direction (or a rolling direction) for hiding layers which have slipped along the receiving space at the one side of the display panel DP may be decreased. Furthermore, the opposite sides of the display panel DP which face away from each other in the second direction DR2 and on which a slip does not occur may not be covered by the bracket EDC and may be exposed to outside the housing. Accordingly, the planar area of the display surface DSa of the display panel DP which is defined between inner surfaces of the housing at the display surface DSa may be increased.

In addition, the guide part GPa may enable the one side of the display panel DP to be moved into the bracket EDC without being separated from the bracket EDC to the outside. Accordingly, the folding reliability of the electronic device EDa may be improved.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device comprising:
a display panel (DP) foldable about a folding axis, the display panel including a first panel portion (AA1) in which the folding axis is defined, a bending portion (BA) at which the display panel is bendable, and a second panel portion (AA2) arranged in a first direction, the folding axis of the display panel extended in a second direction crossing the first direction;
a window (WIN) disposed on the display panel (DP), the window including a first portion adjacent to the bending portion and a second portion which is spaced apart from the first portion along the first direction; and
a bracket (EDC) in which the display panel and the window are received, the bracket including:
a first bracket (BR1) corresponding to the first panel portion, the bending portion (BA) and the second panel portion;
a second bracket (BR2) which extends from the first bracket, toward the window, and covers the first portion; and
a third bracket (BR3) which extends from the first bracket, toward the window, spaced apart from the second bracket along the first direction and covers the second portion,
wherein folding and unfolding of the display panel about the folding axis includes movement of the second portion along the first direction, within the bracket.

2. The display device of claim 1, further comprising a molded member (MP1) between the window and the bracket,
wherein
the display panel which is bendable at the bending portion includes the second panel portion overlapping the first panel portion, and
the molded member covers the bending portion which is bendable and the second panel portion which overlaps the first panel portion.

3. The display device of claim 1 or 2, wherein
within the bracket (EDC) includes:
a first receiving groove (2-1, 2-2) is defined by the first bracket with the second bracket,
a second receiving groove (2-1, 2-2) is defined by the first bracket with the third bracket,
the first portion extends along the second bracket and into the first receiving groove (2-1, 2-2), along the first direction, and
the second portion extends along the third bracket and into the second receiving groove (2-1, 2-2), and
the display device is configured such that the folding and unfolding of the display panel moves the second portion along the third bracket, within the second receiving groove (2-1, 2-2), and/or, further comprising within the bracket (EDC):
a protrusion (BPP) which is connected to the bracket at an upper surface (1-1, 1-2) of the first bracket,
the first receiving groove (2-1, 2-2) extended between the protrusion and the second bracket, and
a first adhesive member (GRP1) which bonds the first portion to the first bracket, at the protrusion.

4. The display device of claim 3, wherein the first panel portion (AA1) of the display panel includes a first display region and a second display region at opposing sides of the folding axis, and/or, further comprising within the bracket (EDC), a guide which is between the window and the first bracket and along which the movement of the window is guided along the first direction.

5. The display device of any of the preceding claims, wherein
the guide (GPa) includes:
a wheel (WH) between the window and the first bracket, and
a track (CT) which is engaged with the wheel and moveable along the wheel,
the track including:
a first track portion (CT1) between the wheel and the first bracket,
a second track portion (CT2) between the wheel and the window, and
a bent track portion (CBT) which connects the first track portion and the second track portion to each other; and
the display device is configured such that when the display is unfolded,
the first track portion (CT1) has a length extended along the first bracket,
the second track portion (CT2) has a length extended along the window, and
within the second receiving groove (2-1, 2-2), the second portion has a length extended along the third bracket.

6. The display device of claim 5, wherein the display device is configured such that when in-folding of the display panel in which the first display region and the second display region of the first panel portion face each other,
the length of the first track portion is increased,
the length of the second track portion is decreased, and
within the second receiving groove (2-1, 2-2), the second portion is moved toward the first bracket and having the length of the second portion increased, and/or wherein the display device is configured such that when out-folding of the display panel in which the first display region and the second display region of the first panel portion face away from each other,
the length of the first track portion is decreased,
the length of the second track portion is increased, and
within the second receiving groove (2-1, 2-2), the second portion is moved away from the first bracket and having the length of the second portion decreased.

7. The display device of any of claims 1 to 4, wherein
the guide (GPb) includes:
a first guide plate (GPT1) which is connected to the first bracket and defines a guide groove of the first guide plate; and
a second guide plate (GPT2) which is connected to the second portion, the second guide plate including a guide rib moveable along the guide groove, in the first direction, and
the display device is configured such that when the display panel which is unfolded ,
the guide rib has a length within the guide groove, and
within the second receiving groove (2-1, 2-2), the second portion has a length extended along the third bracket.

8. The display device of claim 7, wherein the display device is configured such that when in-folding of the display panel in which the first display region and the second display region of the first panel portion face each other,
the length of the guide rib is decreased, and
within the second receiving groove (2-1, 2-2), the second portion is moved toward the first bracket and having the length of the second portion increased, and/or wherein the display device is configured such that when out-folding of the display panel in which the first display region and the second display region face away from each other,
the length the guide rib is increased, and
within the second receiving groove (2-1, 2-2), the second portion is moved away from the first bracket and having the length of second portion decreased.

9. The display device of any of claims 1 to 4, wherein
the guide includes a roller (ROL) between the second portion and the first bracket, and
the display device is configured such that when the display panel is unfolded, within the second receiving groove (2-1, 2-2), the second portion has a length extended along the third bracket, the length extended from the roller to an end of the window at the second portion.

10. The display device of claim 9, wherein the display device is configured such that when in-folding of the display panel in which the first display region and the second display region of the first panel portion face each other, within the second receiving groove (2-1, 2-2), the second portion is moved along the roller, toward the first bracket, and having the length of the second portion increased, and/or
wherein the display device is configured such that when out-folding of the display panel in which the first display region and the second display region face away from each other, within the second receiving groove (2-1, 2-2), the second portion is moved along the roller, away from the first bracket, and the length of the second portion is decreased.

11. The display device of any of the preceding claims, wherein
the bracket further includes a fourth bracket (BR4) extended in the first direction,
the fourth bracket (BR4) including:
a first sidewall (WB1) disposed on both sides of the first bracket opposing each other in the second direction and have a first width along the second direction,
a second sidewall (WB2) extended from upper surface (1-1, 1-2) of the first sidewall and having a second width in the second direction, and
the first width greater than the second width, and
the window further including a third window portion which is extended further than the display panel in the second direction and overlaps the upper surface (1-1, 1-2) of the first sidewalls, and/or, further comprising a second adhesive member (GRP2) which is between the first sidewalls and the third window portion and bonds the first sidewalls and the window to each other, respectively.

12. The display device of any of the preceding claims, further comprising:
an edge of the third bracket which is furthest from the first bracket and a length of the third bracket which extends from the edge of the third bracket and overlaps the window,
a gap which is defined between the length of the third bracket and the window which is overlapped by the length, the gap being open to outside the display device at the edge, and
a tip portion (TP) which is disposed within the gap.

13. A display device comprising:
a display panel (DP) including a display region at which the display panel is rollable;
a window disposed on the display panel, the window including a first portion and a second portion spaced apart from each other in a first direction; and
a bracket in which the display panel and the window are received, the bracket including:
a first bracket (BR1) disposed under the display panel,
a second bracket (BR2) which extends from the first bracket and along which the first portion extends,
a third bracket (BR3) which extends from the first bracket, is opposite to the second bracket along the first direction, and along which the second portion extends to have a length overlapping the third bracket,
a first receiving groove (2-1, 2-2) defined by the first bracket with the second bracket and into which the first portion extends, and
a second receiving groove (2-1, 2-2) defined by the first bracket with the third bracket and into which the second portion extends,
wherein rolling and unrolling of the display panel includes varying of the length of the second portion which overlaps the third bracket.

14. The display device of claim 13, wherein the display panel (DP) is rollable about a rolling axis extended in a second direction crossing the first direction, and/or, further comprising within the bracket, a guide (GPc) which is between the window and the first bracket (BR1) and along which movement of the window is guided along the first direction.

15. The display device of claim 14, wherein the guide (GPc) includes:
a wheel (ROL) between the window and the first bracket, and
a track (CT) which is engaged with the wheel and moveable along the wheel,
the track including:
a first track portion (CT1) between the wheel and the first bracket,
a second track portion (CT2) between the wheel and the window, and
a bent track portion (CBT) which connects the first track portion and the second track portion to each other; and
the display device is configured such that when the display panel is unrolled the first track portion has a length extended along the first bracket, and
the second track portion has a length extended along the window.

16. The display device of claim 15, wherein the display device is configured such that when out-rolling of the display panel in which the display region is exposed to outside the display panel,
the length of the first track portion is decreased,
the length of the second track portion is increased, and
within the second receiving groove (2-1, 2-2), the second portion is moved away from the first bracket and having the length of the second portion decreased, and/or wherein the display device is configured such that when in-rolling of the display panel in which the display region is not exposed to outside the display panel,
the length of the first track portion is increased,
the length of the second track portion is decreased, and
within the second receiving groove (2-1, 2-2), the second portion moved toward the first bracket and having the length of the second portion increased.

17. The display device of claim 14, wherein
the guide (GPb) includes:
a first guide plate (GPT1) which is connected to the first bracket and defines a guide groove of the first guide plate; and
a second guide plate (GPT2) which is connected to the second portion, the second guide plate including a guide rib moveable along the guide groove, in the first direction, and
the display device is configured such that when the display panel is is unrolled, the guide rib has a length within the guide groove.

18. The display device of claim 17, wherein the display device is configured such that when out-rolling of the display panel in which the display region is exposed to outside the display panel,
the length of the guide rib is increased, and
within the second receiving groove (2-1, 2-2), the second portion is moved away from the first bracket and having the length of the second portion decreased, and/or wherein the display device is configured such that when in-rolling of the display panel in which the display region is not exposed to outside the display panel,
the length of the guide rib is decreased, and
within the second receiving groove (2-1, 2-2), the second portion is moved toward the first bracket and having the length of the second portion increased.

19. The display device of claim 14, wherein
the guide includes a roller between the second portion and the first bracket, and
the display device is configured such that when the display panel is unrolled, the length of the second portion is extended from the roller to an end of the window at the second portion.

20. The display device of claim 19, wherein the display device is configured such that when out-rolling of the display panel in which the display region is exposed to outside the display panel,
within the second receiving groove (2-1, 2-2), the second portion is moved along the roller and away from the first bracket, and having the length of the second portion decreased, and/or wherein the display device is configured such that when in-rolling of the display panel in which the display region is not exposed to outside the display panel, and
within the second receiving groove (2-1, 2-2), the second portion is moved along the roller and toward the first bracket, and the length of the second portion is increased.

21. The display device of any of claims 13 to 20, further comprising within the bracket:
a protrusion which is connected to the bracket at an upper surface (1-1, 1-2) of the first bracket,
the first receiving groove (2-1, 2-2) extended between the protrusion and the second bracket, and
a first adhesive member which bonds the first portion to the first bracket, at the protrusion.

22. The display device of any of claims 13 to 21, wherein
the bracket further includes a fourth bracket extended in the first direction, the fourth bracket including:
first sidewalls which are opposite to each other along a second direction crossing the first direction and have a first width along the second direction,
second sidewalls respectively extended from upper surface (1-1, 1-2) of the first sidewalls and having a second width in the second direction, and
the first width greater than the second width, and
the window further including a third window portion is extended further than the display panel in the second direction and overlaps the upper surface (1-1, 1-2) of the first sidewalls, and/or, further comprising a second adhesive member which is between the first sidewalls and the window and bonds the first sidewalls and the window to each other, respectively.

23. The display device of any of claims 13 to 22, further comprising:
an edge of the third bracket which is furthest from the first bracket and a length of the third bracket which extends from the edge of the third bracket and overlaps the window,
a gap which is defined between the length of the third bracket and the window which is overlapped by the length, the gap open to outside the display device at the edge, and
a tip portion (TP) which is within the gap.
